# EUROPEAN PATENT APPLICATION

(11) **EP 4 800 682 A1**
(43) Date of publication of application: **02.09.2026**
(21) Application number: 26161390.5
(22) Date of filing: 27.02.2026
(51) Int. Cl.: G09G 3/3233

(54) **DISPLAY DEVICE AND ELECTRONIC APPARATUS INCLUDING THE SAME**

(30) Priority: 28.02.2025 KR 20250026715; 27.05.2025 KR 20250068646
(71) Applicant: Samsung Display Co., Ltd., Yongin-si, Gyeonggi-do 17113 (KR)
(72) Inventor: SHIN, DONG HEE, 17113 Yongin-si (KR); KIM, HYEONGSEOK, 17113 Yongin-si (KR); KIM, YUNMI, 17113 Yongin-si (KR); PARK, DOYEONG, 17113 Yongin-si (KR)
(74) Representative: Taor, Simon Edward William

(57) **Abstract**

A display device includes a pixel including a light-emitting element, a first transistor that operates in response to a potential of a first node and is connected between a first power supply line and a second node, a second transistor connected between a data line and the first node and configured to receive a write scan signal, a third transistor connected between the first node and a reference voltage line and configured to receive a reference scan signal, a first light-emitting control transistor connected between the second node and a first electrode of the light-emitting element and configured to receive a first light-emitting control signal, and a fourth transistor connected between the first electrode of the lights-emitting element and an initialization voltage line and configured to receive the black scan signal. The first light-emitting control line overlaps the black scan line in a plan view.

## Description

### BACKGROUND

Aspects of some embodiments of the present invention relates to a display device and an electronic apparatus including the same.

A display device such as a television, a monitor, a smartphone, and a tablet that displays images to users includes a display panel that displays the images. Various display panels such as liquid crystal display panels, organic light-emitting display panels, electrowetting display panels, and electrophoretic display panels have been developed as display panels.

The display panel includes a plurality of pixels for generating images. Each of the pixels includes a light-emitting element, a plurality of transistors connected to the light-emitting element and a capacitor. As the resolution of a display device increases, there may be a desire for a technique capable of efficiently arranging components of each pixel and wirings connected to the pixel in a limited space.

The above information disclosed in this Background section is only for enhancement of understanding of the background and therefore the information discussed in this Background section does not necessarily constitute prior art.

### SUMMARY

Aspects of some embodiments of the present invention relates to a display device and an electronic apparatus including the same, and for example, to a display device having relatively high resolution and an electronic apparatus includes the same.

Aspects of some embodiments of the present invention include a display device capable of relatively efficiently arranging components of each pixel and wirings connected to the pixel in a limited space, and an electronic apparatus including the same.

A display device according to some embodiments of the present invention includes a display panel including a pixel.

According to some embodiments, the pixel includes a light-emitting element including first and second electrodes, a first transistor operating in response to a potential of a first node and connected between a first power supply line and a second node, a second transistor connected between a data line and the first node and configured to receive a write scan signal, a third transistor connected between the first node and a reference voltage line and configured to receive a reference scan signal, a first light-emitting control transistor connected between the second node and the first electrode of the light-emitting element and configured to receive a first light-emitting control signal through a first light-emitting control line, and a fourth transistor connected between the first electrode of the light-emitting element and an initialization voltage line and configured to receive a black scan signal through a black scan line.

According to some embodiments, an inactive period of the first light-emitting control signal is included in an active period of the black scan signal, and the first light-emitting control line overlaps the black scan line in a plan view.

A display device according to some embodiments of the present invention comprises a display panel including a pixel.

According to some embodiments, the pixel includes a light-emitting element including first and second electrodes, a first transistor operating in response to a potential of a first node and connected between a first power supply line and a second node, a second transistor connected between a data line and the first node and configured to receive a write scan signal, a third transistor connected between the first node and a reference voltage line and configured to receive a reference scan signal, a first light-emitting control transistor connected between the second node and the first electrode of the light-emitting element and configured to receive a shared control signal, and a fourth transistor connected between the first electrode of the light-emitting element and an initialization voltage line and configured to receive the shared control signal.

According to some embodiments, each of the first and fourth transistors is a N-type transistor, and the first light-emitting control transistor is a P-type transistor.

An electronic apparatus according to some embodiments of the present invention comprises a display panel including a pixel, a panel driver configured to drive the display panel, a driving controller configured to control driving of the panel driver, and a processor configured to provide an image signal to the driving controller.

According to some embodiments, the pixel includes a light-emitting element including first and second electrodes, a first transistor operating in response to a potential of a first node and connected between a first power supply line and a second node, a second transistor connected between a data line and the first node and configured to receive a write scan signal, a third transistor connected between the first node and a reference voltage line and configured to receive a reference scan signal, a first light-emitting control transistor connected between the second node and the first electrode of the light-emitting element and configured to receive a first light-emitting control signal through a first light-emitting control line, and a fourth transistor connected between the first electrode of the light-emitting element and an initialization voltage line and configured to receive the black scan signal through a black scan line.

According to an aspect, there is provided a display device as set out in claim 1. Additional features are set out in claims 2 to 8. According to an aspect, there is provided a display device as set out in claim 9. Additional features are set out in claims 10 to 14. According to an aspect, there is provided an electronic apparatus as set out in claim 15.

According to some embodiments, an inactive period of the first light-emitting control signal is included in an active period of the black scan signal, and the first light-emitting control line overlaps the black scan line in a plan view.

### BRIEF DESCRIPTION OF THE DRAWINGS

The above and other aspects and features of embodiments according to the present disclosure will become more apparent by describing in more detail aspects of some embodiments thereof with reference to the accompanying drawings.
FIG. 1 is a block diagram of an electronic apparatus according to some embodiments.
FIG. 2 is a schematic diagram illustrating embodiments of various electronic apparatuses.
FIG. 3 is a perspective view of an electronic apparatus according to some embodiments of the present invention.
FIG. 4 is a cross-sectional view of the electronic apparatus shown in FIG. 3.
FIG. 5 is a cross-sectional view of the display panel illustrated in FIG. 4.
FIG. 6 is a block diagram of a display device according to some embodiments of the present invention.
FIG. 7A is a circuit diagram of one pixel of the pixels shown in FIG. 6.
FIG. 7B is a circuit diagram of a pixel according to some embodiments of the present invention.
FIG. 8 is a waveform diagram showing signals applied to the pixel shown in FIG. 7A.
FIG. 9 is a cross-sectional view of a display panel according to some embodiments of the present invention.
FIGS. 10A to 10G are plan views illustrating a manufacturing process of a display panel according to some embodiments of the present invention.
FIG. 11 is a cross-sectional view taken along a cutting line I-I' shown in FIG. 10E.
FIGS. 12A and 12B are plan views illustrating a manufacturing process of a display panel according to some embodiments of the present invention.
FIG. 13 is a cross-sectional view taken along a cutting line II-II' shown in FIG. 12B.
FIG. 14A is a circuit diagram of a pixel according to some embodiments of the present invention.
FIG. 14B is a waveform diagram illustrating signals applied to the pixel shown in FIG. 14A.
FIG. 15A is a circuit diagram of a pixel according to some embodiments of the present invention.
FIG. 15B is a waveform diagram illustrating signals applied to the pixel shown in FIG. 15A.
FIGS. 16A and 16B are plan views illustrating a manufacturing process of a display panel according to some embodiments of the present invention.
FIG. 17 is a cross-sectional view taken along a cutting line III-III' shown in FIG. 16B.

### DETAILED DESCRIPTION

In this specification, it will be understood that when an element (or a region, a layer, a portion, or the like) is referred to as being "on", "connected to" or "coupled to" another element, it may be directly located on, connected to, or coupled to the other element, or other elements may be located therebetween.

Like reference numerals or symbols refer to like elements throughout. In the drawings, the thickness, ratio, and size of the elements are exaggerated for effectively describing the technical contents. As used herein, the term "and/or" includes any and all combinations of one or more of the associated listed elements.

It will be understood that, although the terms "first", "second", etc. may be used herein to describe various elements, the elements are not to be limited by these terms. These terms are only used to distinguish one element, component, region, layer or section from another element, component, region, layer or section. For instance, a first element, component, region, layer or section discussed below could be termed a second element, component, region, layer or section without departing from the scope of the inventive concept. Similarly, a second element, component, region, layer or section could be termed a first element, component, region, layer or section. In this specification, the singular expressions "a", "an" and "the" are intended to include the plural forms as well, unless the context clearly indicates otherwise.

In addition, the terms "below", "under", "on the lower side", "above", "over", "on the upper side", or the like may be used to describe the relationships between the elements illustrated in the drawings. These terms are relative concepts and are described on the basis of the directions indicated in the drawings.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, aspects of some embodiments of the present disclosure are described in more detail with reference to the drawings.

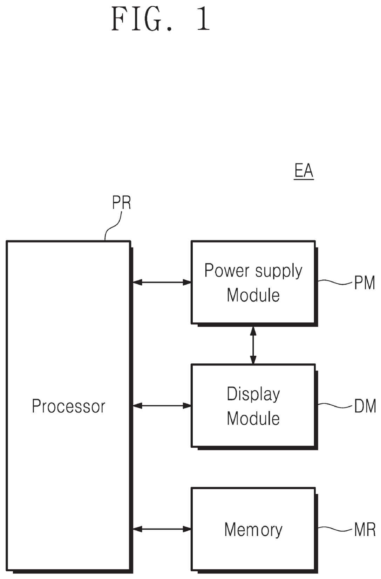

FIG. 1 is a block diagram of an electronic apparatus according to some embodiments.

Referring to FIG. 1, an electronic apparatus EA according to some embodiments may include a display module (or a display device DM), a processor PR, a memory MR, and a power supply module PM.

The processor PR may include at least one of a central processing unit (CPU), an application processor (AP), a graphics processing unit (GPU), a communication processor (CP), an image signal processor (ISP), or a controller.

The memory MR may store data information necessary for the operation of the processor PR or the display module DM. When the processor PR executes an application stored in the memory MR, an image data signal and/or an input control signal are transmitted to the display module DM, and the display module DM may process the received signal and output image information through a display screen. The display module DM may include a display panel that displays images.

The power supply module PM may include a power conversion module. The power conversion module may convert power supplied by the power supply module, such as a power adapter or a battery device, to generate power required for operation of the electronic apparatus EA.

At least one of the respective components of the electronic apparatus EA described above may be included in a display module according to some embodiments described below and a display device according to some embodiments including the same. In addition, some of the individual modules that are functionally included in one module may be included in the display device, and other parts may be provided separately from the display device. For example, the display device includes a display module DM, and the processor PR, the memory MR, and the power supply module PM may be provided in the form of other devices in the electronic apparatus EA other than the display device.

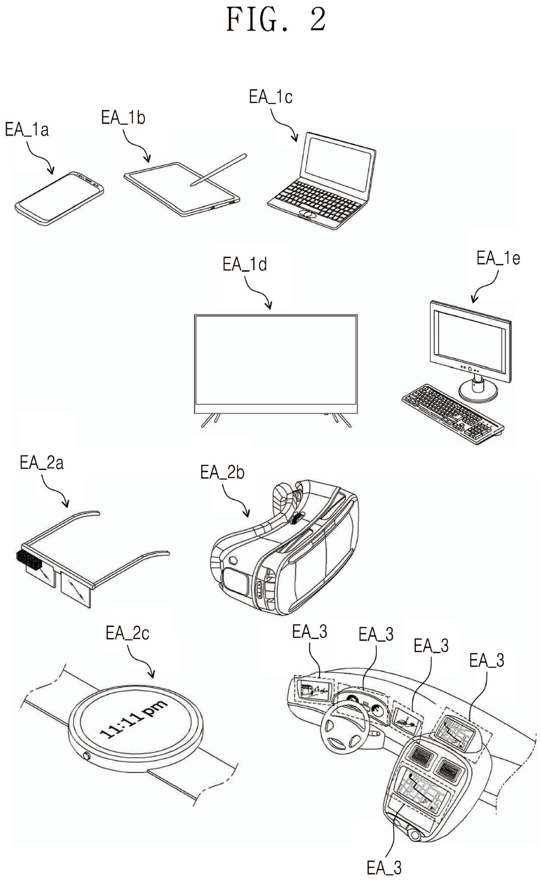

FIG. 2 is a schematic diagram illustrating embodiments of various electronic apparatuses.

Referring to FIG. 2, various electronic apparatuses including a display module (or a display device) according to some embodiments may include not only an electronic apparatus for image display such as a smartphone EA_1a, a tablet PC EA_1b, a laptop EA_1c, a TV EA_1d, and a desk monitor EA_1e, but also a wearable electronic apparatus such as smart glasses EA_2a, a head mounted display EA_2b, and a smart watch EA_2c, an electronic apparatus for a vehicle EA_3 such as a CID (Center Information Display) located on an instrument panel, a center fascia, and a dashboard of a vehicle, and a room mirror display.

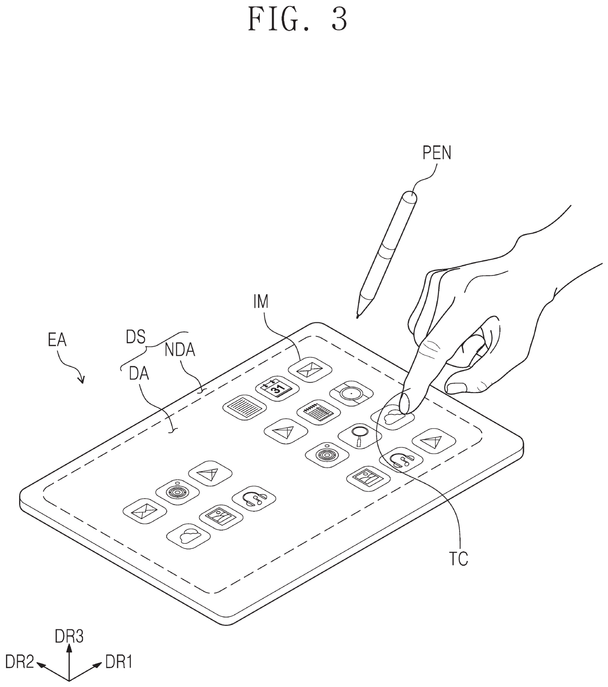

FIG. 3 is a perspective view of an electronic apparatus according to some embodiments of the present invention.

Referring to FIG. 3, the electronic apparatus EA may include long sides extending parallel to a first direction DR1 and short sides extending parallel to a second direction DR2 intersecting the first direction DR1, respectively. However, this is illustrated by way of example, and the electronic apparatus EA may include sides of the same length with respect to each of the first direction DR1 and the second direction DR2, and embodiments are not limited thereto.

Hereinafter, a direction perpendicularly (or substantially perpendicularly) intersecting the plane defined by the first direction DR1 and the second direction DR2 is defined as a third direction DR3. In addition, in the present specification, the phrase "when viewed in a plane (or on a plane, or in a plan view)" is defined as a state viewed in the third direction DR3.

A front surface of the electronic apparatus EA may be defined as a display surface DS, and may have a plane defined by the first direction DR1 and the second direction DR2. Images IM generated by the electronic apparatus EA may be provided to the user through the display surface DS.

The display surface DS may include a display area DA and a non-display area NDA around (e.g., surrounding, in a periphery, or outside a footprint of) the display area DA. The display area DA may be an area where images are displayed, and the non-display area NDA may be an area in which the image is not displayed. The non-display area NDA may be adjacent to at least one side of the display area DA. According to some embodiments, the non-display area NDA may have a frame shape surrounding (e.g., in a periphery or outside a footprint of) the display area DA. However, this is illustrated as an example, and according to some embodiments of the present invention, the non-display area NDA may be omitted, and in this case, the display surface DS may consist only of the display area DA.

The electronic apparatus EA may sense inputs applied external to the electronic apparatus EA. For example, the electronic apparatus EA may sense a first input by the touch TC and a second input by the touch pen PEN. The first input by the touch TC may include various types of external inputs, such as part of the user's body, light, heat, or pressure. The touch pen PEN may be an active pen or an electromagnetic pen, and embodiments are not limited thereto. The touch pen PEN may be defined as an input device, and the display area DA may provide a user with a sensing area capable of sensing an input in addition to displaying an image.

According to some embodiments, the electronic apparatus EA may be a large electronic apparatus such as a television, a monitor, or an external billboard. In addition, the electronic apparatus EA may be a small or medium-sized electronic apparatus such as a personal computer, a notebook computer, a personal digital terminal, an automobile navigation unit, a game machine, a smartphone, a tablet, and a camera. However, it is illustrative, and may be employed as another electronic apparatus without departing from the scope of embodiments according to the present invention. FIG. 3 shows that the electronic apparatus EA is a tablet device as an example, but embodiments according to the present disclosure are not limited thereto.

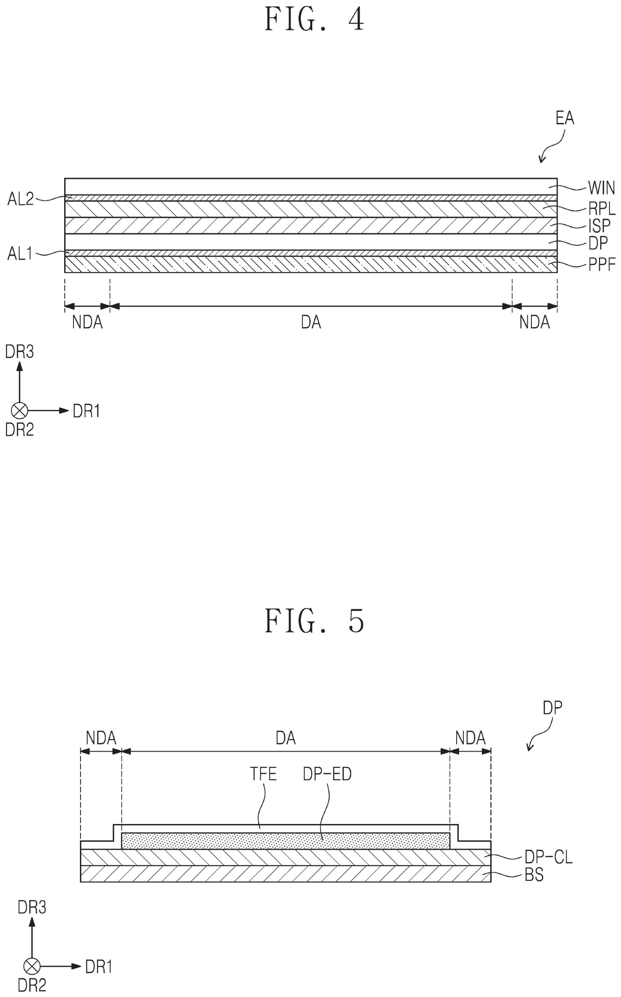

FIG. 4 is a cross-sectional view of the electronic apparatus shown in FIG. 3. FIG. 5 is a cross-sectional view of the display panel illustrated in FIG. 4.

Referring to FIG. 4, the electronic apparatus EA may include a display panel DP, an input sensor ISP, an antireflection layer RPL, a window WIN, a panel protective film PPF, and first and second adhesive layers AL1 and AL2.

The display panel DP according to some embodiments of the present invention may be a light-emitting display panel. For example, the display panel DP may be an organic light-emitting display panel or an inorganic light-emitting display panel. The light-emitting layer of the organic light-emitting display panel may include an organic light-emitting material. The light-emitting layer of the inorganic light-emitting display panel may include a quantum dot, a quantum rod, or the like. Hereinafter, the display panel DP will be described as the organic light-emitting display panel as an example, but embodiments according to the present disclosure are not limited thereto.

Referring to FIG. 5, the display panel DP may include a substrate BS, a circuit element layer DP-CL, a display element layer DP-ED, and a thin film encapsulation layer TFE. The circuit element layer DP-CL, the display element layer DP-ED, and the thin film encapsulation layer TFE may be sequentially arranged on the substrate BS.

The substrate BS may include glass or may include a flexible plastic material such as polyimide (PI).

A plurality of pixels may be located in the circuit element layer DP-CL and the display element layer DP-ED. Each of the pixels may include a transistor located in the circuit element layer DP-CL and a light-emitting element located in the display element layer DP-ED and connected to the transistor.

The thin film encapsulation layer TFE may be located on the circuit element layer DP-CL to cover the display element layer DP-ED. The thin film encapsulation layer TFE may protect the pixels from moisture, oxygen, and external foreign matter. According to some embodiments, the thin film encapsulation layer TFE cover an entire area of the substrate BS, but according to some embodiments of the present invention, the substrate BS may include a partial area exposed from the thin film encapsulation layers TFE. Alternatively, a region exposed from the thin film encapsulation layer TFE may be formed along the edge of the substrate BS, which is not limited to any one embodiment.

Referring to FIG. 4, the input sensor ISP may be located on the display panel DP. The input sensor ISP may include a plurality of sensing units for sensing an external input in a capacitive manner. The input sensor ISP may be directly formed on the display panel DP when the electronic apparatus EA is manufactured. Specifically, a conductive pattern or an insulating layer constituting the input sensor ISP may be directly deposited or patterned on the display panel DP. However, embodiments of the present invention are not limited thereto, and the input sensor ISP may be manufactured as a panel separated from the display panel DP and attached to the display panel DP through an adhesive layer.

Referring to FIG. 4, the anti-reflection layer RPL may be located on the input sensor ISP. The anti-reflection layer RPL may reduce the external light reflectance of the electronic apparatus EA to relatively improve the visibility of an image displayed on the electronic apparatus EA. The anti-reflection layer RPL may include a phase retarder, a polarizer, a black matrix, a color filter, and the like, but embodiments of the present invention are not limited thereto. The anti-reflection layer RPL may be directly formed on the input sensor ISP through a coating or a deposition process, or may be provided in a film form and attached to the input sensor ISP through an adhesive layer, but embodiments of the present invention are not limited thereto.

The window WIN may be located on the antireflection layer RPL. The window WIN may protect the display panel DP, the input sensor ISP, and the anti-reflection layer RPL from external scratches and impacts.

The panel protective film PPF may be located under the display panel DP. The panel protective film PPF may support the display panel DP and protect a lower portion of the display panel DP. The panel protective film PPF may have insulating properties. For example, the panel protective film PPF may include a resin such as polyethylene terephthalate (PET), polyimide, or polypropylene (PP), but embodiments of the present invention are not limited thereto.

The first adhesive layer AL1 is located between the display panel DP and the panel protective film PPF, and the display panel DP may be bonded to the panel protective film PPF by the first adhesive layer AL1. The second adhesive layer AL2 is located between the window WIN and the anti-reflection layer RPL, and the window WIN may be bonded to the anti-reflective layer RPL by the second adhesive layer AL2.

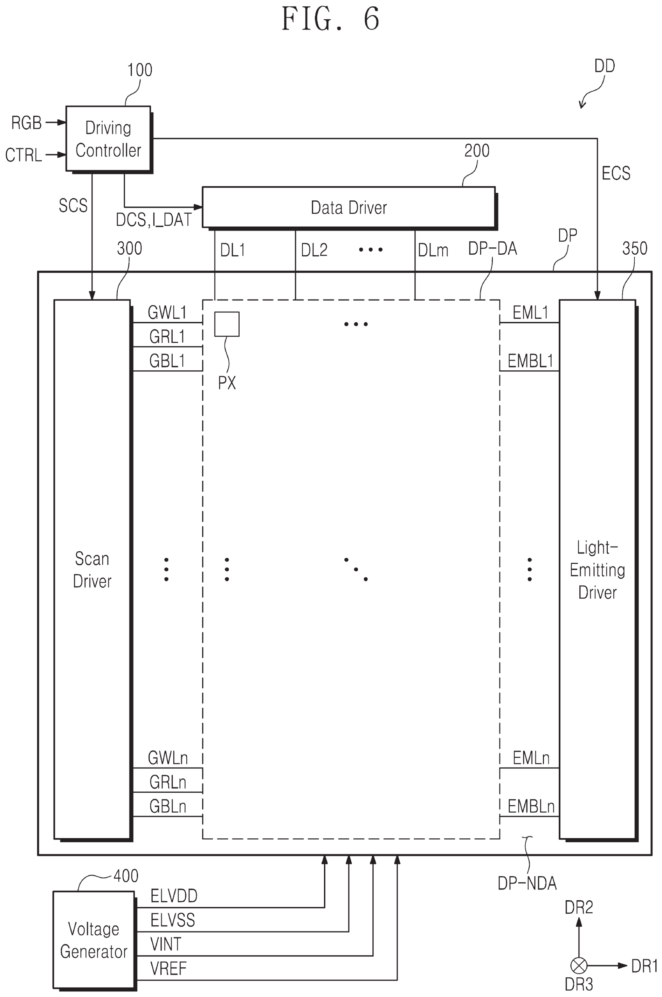

FIG. 6 is a block diagram of a display device according to some embodiments of the present invention.

Referring to FIG. 6, a display device DD includes a display panel DP, a panel driver, and a driving controller 100. According to some embodiments of the present invention, the panel driver includes a data driver 200, a scan driver 300, a light-emitting driver 350, and a voltage generator 400.

The driving controller 100 receives an image signal RGB and a control signal CTRL from the processor PR (see FIG. 1). The driving controller 100 generates image data I_DAT obtained by converting a data format of the image signal RGB to meet the interface specification with the data driver 200. The driving controller 100 generates a first control signal SCS, a second control signal ECS, and a third control signal DCS based on the control signal CTRL.

The data driver 200 receives the third control signal DCS and the image data I_DAT from the driving controller 100. The data driver 200 converts the image data I_DAT into data signals (or data voltages) and outputs the data signals to a plurality of data lines DL1 to DLm to be described later. The data signals are analog voltages corresponding to grayscale values of the image data I_DAT.

The scan driver 300 receives the first control signal SCS from the driving controller 100. The scan driver 300 may output scan signals to scan lines in response to the first control signal SCS.

The voltage generator 400 generates voltages used for operation of the display panel DP. According to some embodiments, the voltage generator 400 generates a first power supply voltage ELVDD, a second power supply voltage ELVSS, a reference voltage VREF, and an initialization voltage VINT.

The display panel DP may include a display area DP-DA corresponding to the display area DA (shown in FIG. 1) and a non-display area DP-NDA corresponding to the non-display area NDA (shown in FIG. 1).

The display panel DP may include a plurality of pixels PX located in the display area DP-DA. Although FIG. 6 illustrates a single pixel PX for convenience of illustration, as a person having ordinary skill in the art would appreciate, the display panel DP may include any suitable number of pixels PX according to the design and size of the display panel DP.

The display panel DP further includes write scan lines GWL1 to GWLn, reference scan lines GRL1 to GRLn, black scan lines GBL1 to GBLn, first light-emitting control lines EMBL1 to EMBLn, second light-emitting control lines EML1 to EMLn, and data lines DL1 to DLm. The write scan lines GWL1 to GWLn, the reference scan lines GRL1 to GRLn, the black scan lines GBL1 to GBLn, the first light-emitting control lines EMBL1 to EMBLn, and the second light-emitting control lines EML1 to EMLn extend in the first direction DR1. The write scan lines GWL1 to GWLn, the reference scan lines GRL1 to GRLn, the black scan lines GBL1 to GBLn, the first light-emitting control lines EMBL1 to EMBLn, and the second light-emitting control lines EML1 to EMLn are arranged to be spaced apart from each other in the second direction DR2. The data lines DL1 to DLm extend in the second direction DR2 and are arranged to be spaced apart from each other in the first direction DR1. Here, n and m are natural numbers of 1 or more.

The plurality of pixels PX are electrically connected to the write scan lines GWL1 to GWLn, the reference scan lines GRL1 to GRLn, the black scan lines GBL1 to GBLn, the first light-emitting control lines EMBL1 to EMBLn, the second light-emitting control lines EML1 to EMLn, and the data lines DL1 to DLm, respectively. For example, each of the plurality of pixels PX may be electrically connected to three scan lines and two light-emitting control lines. However, the number of scan lines and the number of light-emitting control lines connected to each pixel PX are not limited thereto, and may be changed.

The scan driver 300 may be located in the non-display area DP-NDA of the display panel DP. The scan driver 300 receives the first control signal SCS from the driving controller 100. The scan driver 300 may output write scan signals to the write scan lines GWL1 to GWLn, output reference scan signals to the reference scan lines GRL1 to GRLn, and output black scan signals to the black scan lines GBL1 to GBLn in response to the first control signal SCS.

The light-emitting driver 350 may be located in the non-display area DP-NDA of the display panel DP. The light-emitting driver 350 receives the second control signal ECS from the driving controller 100. The light-emitting driver 350 may output first light-emitting control signals to the first light-emitting control lines EMBL1 to EMBLn and output second light-emitting control signal to the second light-emitting control lines EML1 to EMLn in response to the second control signal ECS.

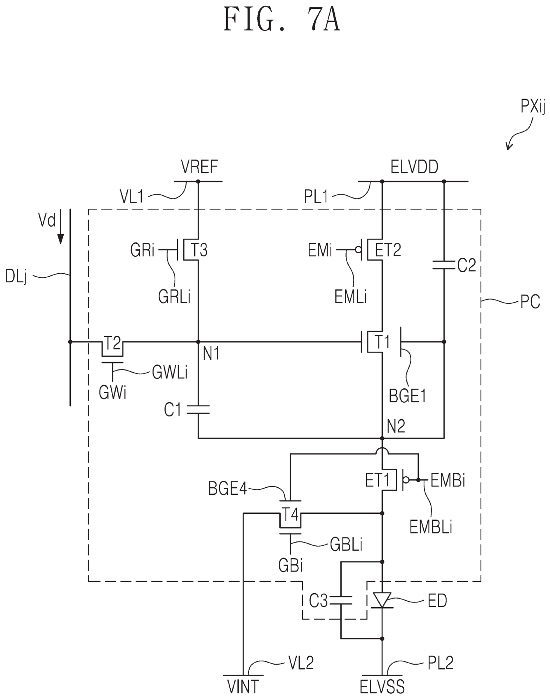

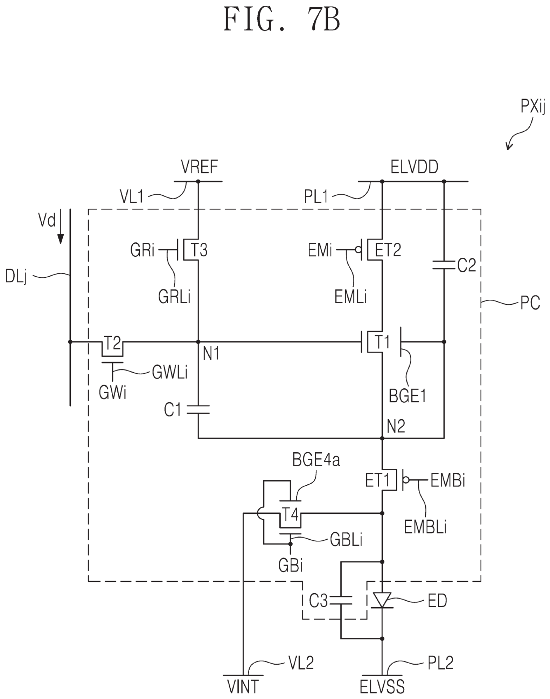

FIG. 7A is a circuit diagram of one pixel of the pixels shown in FIG. 6. FIG. 7B is a circuit diagram of a pixel according to some embodiments of the present invention. Although FIGS. 7A and 7B illustrate various components in a pixel according to some embodiments, embodiments according to the present disclosure are not limited thereto, and according to various embodiments, the pixel may include additional components, or fewer components, without departing from the spirit and scope of embodiments according to the present disclosure.

In FIGS. 7A and 7B, an equivalent circuit diagram of one pixel PXij among the plurality of pixels PX illustrated in FIG. 6 is illustrated as an example of the present invention. Because each of the plurality of pixels PX has the same circuit structure, the circuit structure of the pixel PXij is described to replace the detailed description of the remaining pixels.

Referring to FIGS. 7A and 7B, the pixel PXij may include a light-emitting element ED and a pixel circuit PC. The light-emitting element ED may be a light-emitting diode, and for example, the light-emitting element ED may be an organic light-emitting diode including an organic light- emitting layer. The pixel circuit PC may be connected to the light-emitting element ED to control the amount of current flowing through the light-emitting elements ED, and the light-emitting element ED may generate light having a luminance (e.g., a set or predetermined luminance) according to the provided amount of current.

The pixel PXij may be connected to a j-th data line DLj (hereinafter, referred to as a data line), an i-th write scan line GWLi (hereinafter, referred as a write scan line), an i-th reference scan line GRLi (hereinafter, referring to a reference scan line), an i-th black scan line GBLi (hereinafter, referring to a black scan line), an i-th first light-emitting control line EMBLi (hereinafter, referring to a first light-emitting control line), and an i-th second light-emitting control line EMLi (hereinafter, referring to a second light-emitting control line). The pixel circuit PC may include six transistors T1, T2, T3, T4, ET1, and ET2 and three capacitors C1, C2, and C3. The six transistors T1, T2, T3, T4, ET1, and ET2 may include first to fourth transistors T1 to T4 and first and second light-emitting control transistors ET1 and ET2. The three capacitors C1, C2, and C3 may include first to third capacitors C1,C2, and C3.

Each of the first to fourth transistors T1, T2, T3, and T4 may be an N-type transistor including an oxide semiconductor as a semiconductor layer. Each of the first and second light-emitting control transistors ET1 and ET2 may be a P-type transistor including amorphous silicon, low-temperature polycrystalline silicon (LTPS), and crystalline silicon as a semiconductor layer. However, embodiments of the present invention are not limited thereto, for example, each of the first to fourth transistors T1, T2, T3, and T4 and the second light-emitting control transistor ET2 according to some embodiments of the present invention may be an N-type transistor, and only the first light-emitting control transistor ET1 may be a P-type transistor.

The write scan signal GWi is applied to the write scan line GWLi, the reference scan signal GRi is applied to the reference scan line GRLi, and the black scan signal GBi is applied to the black scan line GBLi. The first light-emitting control signal EMBi may be applied to the first light-emitting control line EMBLi, and the second light-emitting control signal EMi may be applied to the second light-emitting control line EMLi. A data signal Vd may be applied to the data line DLj.

The first power supply voltage ELVDD is applied to the first power supply line PL1, and the second power supply voltage ELVSS is applied to the second power supply line PL2. The second power voltage ELVSS may have a lower voltage level than the first power voltage ELVDD. The reference voltage VREF is applied to the reference voltage line VL1, and the initialization voltage VINT is applied to the initialization voltage line VL2.

The light-emitting element ED is connected to the pixel circuit PC and may output light in response to a driving current provided through the pixel circuit PC. The light-emitting element ED may include a first electrode (that is, referred to as an anode) connected to the pixel circuit PC and a second electrode (that is, referred to as a cathode) connected to the second power supply line PL2.

Each of the six transistors T1, T2, T3, T4, ET1, and ET2 may include a source, a drain, and a gate electrode. Hereinafter, in FIGS. 7A and 7B, for convenience, either one of the source and the drain may be referred to as a first electrode, and the other may be referred to a second electrode. In addition, the gate electrode may be referred to as a control electrode.

The first transistor T1 operates in response to a potential of a first node N1 and is connected between the first power supply line PL1 and a second node N2. The first transistor T1 may include a source electrically connected to the first power supply line PL1, a drain connected to the second node N2, and a gate electrode connected to the first node N1. The first transistor T1 may be referred to as a driving transistor. According to some embodiments, the first transistor T1 may further include a back gate electrode BGE1 connected to the second node N2. The back gate electrode BGE1 may source-synchronize the first transistor T1 through the second node N2, and the first transistor T1 may have a low resistance value through a source follower compensation scheme. The first transistor T1 may be an N-type transistor. For example, the first transistor T1 may have an NMOS structure.

The second transistor T2 is connected between the data line DLj and the first node N1, and receives the write scan signal GWi. The second transistor T2 may include a source connected to the data line DLj, a drain connected to the first node N1, and a gate electrode that receives the write scan signal GWi. The gate electrode of the second transistor T2 may be connected to the write scan line GWLi. The second transistor T2 may be referred to as a switching transistor. The second transistor T2 may be an N-type transistor. For example, the second transistor T2 may have an NMOS structure.

The third transistor T3 is connected between the first node N1 and the reference voltage line VL1, and receives the reference scan signal GRi. The third transistor T3 may include a source connected to the reference voltage line VL1, a drain connected to the first node N1, and a gate electrode that receives the reference scan signal GRi. The gate electrode of the third transistor T3 may be connected to the reference scan line GRLi. The third transistor T3 may be an N-type transistor. For example, the third transistor T3 may have an NMOS structure.

The fourth transistor T4 is connected between the first electrode of the light-emitting element ED and the initialization voltage line VL2, and receives the black scan signal GBi. The fourth transistor T4 may include a source connected to the initialization voltage line VL2, a drain connected to the first electrode of the light-emitting element ED, and a gate electrode that receives the black scan signal GBi. The gate electrode of the fourth transistor T4 may be connected to the black scan line GBLi. The fourth transistor T4 may be an N-type transistor. For example, the fourth transistor T4 may have an NMOS structure.

The first light-emitting control transistor ET1 is connected between the second node N2 and the first electrode of the light-emitting element ED, and receives the first light-emitting control signal EMBi. The first light-emitting control transistor ET1 may include a drain connected to the second node N2, a source connected to the first electrode of the light-emitting element ED, and a gate electrode that receives the first light-emitting control signal EMBi. The gate electrode of the first light-emitting control transistor ET1 may be connected to the first light- emitting control line EMBLi. The first light-emitting control transistor ET1 may be a P-type transistor. For example, the first light-emitting control transistor ET1 may have a PMOS structure.

According to some embodiments, the fourth transistor T4 may further include a back gate electrode BGE4 connected to the first light-emitting control line EMBLi. However, embodiments of the present invention are not limited thereto. As illustrated in FIG. 7B, a back gate electrode BGE4a of the fourth transistor T4 may be connected to the gate electrode (or the black scan line GBLi) of the fourth transistorT4.

The second light-emitting control transistor ET2 is connected between the first power supply line PL1 and the first transistor T1, and receives the second light-emitting control signal EMi. The second light-emitting control transistor ET2 may include a drain connected to the first power supply line PL1, a source connected to a source of the first transistor T1, and a gate electrode that receives the second light-emitting control signal EMi. The gate electrode of the second light-emitting control transistor ET2 may be connected to the second light-emitting control line EMLi. The second light-emitting control transistor ET2 may be a P-type transistor. For example, the second light-emitting control transistor ET2 may have a PMOS structure.

The first capacitor C1 is connected between the first node N1 and the second node N2, and may charge a voltage corresponding to a potential difference between the first node N1 and the second node N2. The first capacitor C1 may be referred to as a storage capacitor. The first transistor T1 may control the amount of current supplied to the light-emitting element ED according to the voltage charged in the first capacitor C1 to adjust the amount of light emitted from the light-emitting element ED. The second capacitor C2 is connected between the first power supply line PL1 and the second node N2, and may charge a voltage corresponding to a potential difference between the first power source line PL1 and second node N2. The second capacitor C2 may be referred to as a hold capacitor. The third capacitor C3 may be connected between the first electrode of the light-emitting element ED and the second electrode (or the second power supply line PL2) of the light-emitting element ED. The third capacitor C3 may charge a voltage corresponding to a potential difference between the first and second electrodes of the light-emitting element ED. The third capacitor C3 may be a parasitic capacitor formed in the light-emitting element ED.

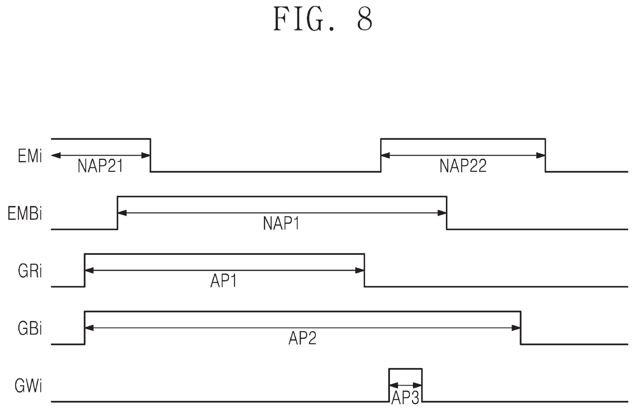

FIG. 8 is a waveform diagram showing signals applied to the pixel shown in FIG. 7A.

Referring to FIGS. 7A and 8, each of the first to fourth transistors T1, T2, T3, and T4 may be an N-type transistor. Each of the first to fourth transistors T1, T2, T3, and T4 may be turned on when a signal received by the gate electrode is at a high level, and may be turned off when the signal received by the gate electrode is at a low level. Therefore, an active period of each of the write scan signal GWi, the reference scan signal GRi, and the black scan signal GBi may be defined as a high-level period, and an inactive period of each of the write scan signal GWi, the reference scan signal GRi, and the black scan signal GBi may be defined as a low-level period.

Each of the first and second light-emitting control transistors ET1 and ET2 may be a P-type transistor. Each of the first and second light-emitting control transistors ET1 and ET2 may be turned on when a signal received by the gate electrode is at a low level, and may be turned off when a signal received by the gate electrode is at a high level. Therefore, an active period of each of the first and second light-emitting control signals EMBi and EMi may be defined as a low-level period, and the inactive period each of the first and second light-emitting control signals EMBi and EMi may be defined as a high-level period.

The third transistor T3 is turned on during the active period AP1 (hereinafter, a first active period) of the reference scan signal GRi, and the first node N1 may be initialized to the reference voltage VREF through the turned on third transistor T3. The fourth transistor T4 is turned on during the active period AP2 (hereinafter, a second active period) of the black scan signal GBi, and the first electrode of the light-emitting element ED may be initialized to the initialization voltage VINT through the turned on fourth transistor T4. According to some embodiments of the present invention, the second active period AP2 and the first active period AP1 may overlap each other. The first active period AP1 may be included in the second active period AP2. In addition, a duration of the second active period AP2 may be greater than a duration of the first active period AP1.

The second transistor T2 is turned on during the active period AP3 (hereinafter, a third active period) of the write scan signal GWi, and the data signal Vd may be applied to the first node N1 through the turned on second transistor T2. Therefore, the potential of the first node N1 may be changed from the reference voltage VREF to the data signal Vd. The change amount "VREF-Vd" of the first node N1 may be reflected in the second node N2 by the first capacitor C1. The third active period AP3 may be non-overlapping with the first active period AP1. Therefore, when the second transistor T2 is turned on, the third transistor T3 may be turned off.

Thereafter, even if the potential of the second node N2 changes, the gate-source voltage of the first transistor T1 may be kept constant because the amount of change of the second nodeN2 is reflected in the first node N1 by the first capacitor C1.

The first light-emitting control transistor ET1 may be turned off during the inactive period NAP1 (hereinafter, referred to as a first inactive period) of the first light-emitting control signal EMBi. The first non-active period NAP1 overlaps with the second active period AP2. In particular, the first inactive period NAP1 may be included in the second active period AP2. According to some embodiments of the present invention, the duration of the second active period AP2 may be greater than a duration of the first inactive period NAP1.

The second light-emitting control transistor ET2 may be turned off during an inactive period (hereinafter, a second inactive period) of the second light-emitting control signal EMi. The second inactive period may include a first sub-inactive period NAP21 and a second sub-inactivity period NAP22. The first sub-inactive period NAP21 may partially overlap the first and second active periods AP1 and AP2, and the second sub-inactive period NAP22 may partially overlap the second and third active periods AP2 and AP3.

During the first and second inactive periods NAP1, NAP21, and NAP22, the first or second light-emitting control transistors ET1 and ET2 are turned off, and thus no driving current flows through the light-emitting element ED. When both the first and second light-emitting control signals EMBi and EMi are switched to the low level state, the first and second lights-emitting control transistors ET1 and ET2 are turned on, so that the driving current may flow through the light-emitting element ED.

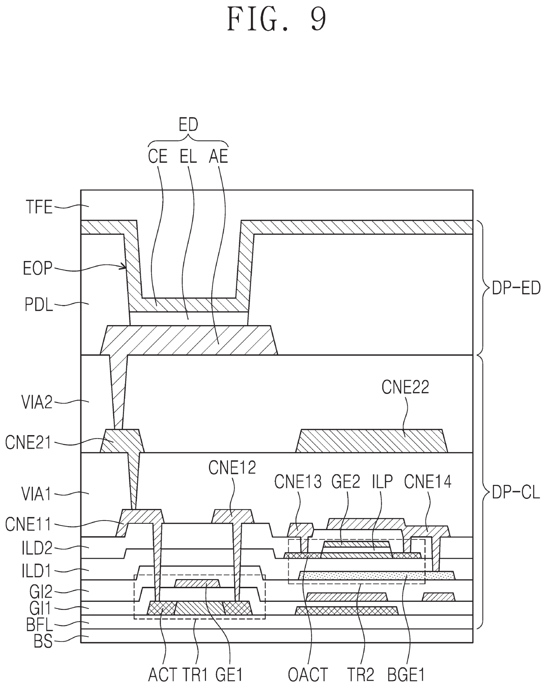

FIG. 9 is a cross-sectional view of a display panel according to some embodiments of the present invention.

Referring to FIG. 9, the display panel DP may include a substrate BS, a circuit element layer DP-CL, a display element layer DP-ED, and a thin film encapsulation layer TFE.

The display panel DP may include a plurality of insulating layers, a semiconductor pattern, a conductive pattern, a signal line, and the like. An insulating layer, a semiconductor layer, and a conductive layer are formed by a method such as coating or vapor deposition. Then, the insulating layer, the semiconductor layer, and the conductive layer can be selectively patterned by photolithography and etching processes. In this manner, the semiconductor pattern, the conductive pattern, the signal line, and the like included in the circuit element layer DP-CL and the display element layer DP-ED can be formed.

The substrate BS may include a glass substrate, a sapphire substrate, a plastic film, or an organic/inorganic laminated film. The substrate BS may have a multi-layer structure or a single-layer structure. For example, the substrate BS may have a stacked-layer structure of a plurality of plastic films bonded with an adhesive, or may have a stacked layer structure of a glass substrate and a plastic film bonded with the adhesive. The substrate BS may have flexibility. For example, the substrate BS may include polyimide. However, embodiments of the present invention are not limited thereto, for example the substrate BS may be provided in a rigid state.

The circuit element layer DP-CL may include pixel circuits, a buffer layer BFL, and a plurality of insulating layers GI1, GI2, ILD1, ILD2, VIA1, and VIA2.

Referring to FIG. 9, the circuit element layer DP-CL may be located on the substrate BS. FIG. 9 illustrates two transistors TR1 and TR2, two capacitors, and a plurality of connection electrodes among pixel circuits for easy description, and illustrates a plurality of insulating layers GI1, GI2, ILD1, ILD2, VIA1, and VIA2 sequentially stacked. The first transistor TR1 of the two transistors may correspond to the first light-emitting control transistor ET1 illustrated in FIG. 7A, and may include a first semiconductor pattern ACT and a first gate electrode GE1. The second transistor TR2 may correspond to the first transistor T1 illustrated in FIG. 7A, and may include a second semiconductor pattern OACT, a second gate electrode GE2, and a back gate electrode BGE1.

The buffer layer BFL may be located on the substrate BS. The buffer layer BFL may relatively improve a coupling force between the substrate BS and the first semiconductor pattern ACT. The buffer layer BFL may include a silicon oxide layer and/or a silicon nitride layer. When the buffer layer BFL includes the silicon oxide layer and the silicon nitride layer, the two layers may be alternately stacked.

The first semiconductor pattern ACT may be located on the buffer layer BFL. According to some embodiments, the first semiconductor pattern ACT may include a crystalline semiconductor material. For example, the first semiconductor pattern ACT may include a polycrystalline semiconductor material such as polycrystalline silicon. The first semiconductor pattern ACT may include a plurality of regions divided according to conductivity. The first semiconductor pattern ACT may include a source region, a channel region, and a drain region. The channel region may be a region having a relatively low electrical conductivity compared to the source region and the drain region. The source region and the drain region may be arranged to be spaced apart from each other with the channel region interposed therebetween.

The first insulating layer GI1 may be located on the buffer layer BFL. The first insulating layer GI1 may commonly overlap the plurality of pixels PX (see FIG. 6) and cover the first semiconductor pattern ACT. The first insulating layer GI1 may be an inorganic layer and/or an organic layer, and may have a single-layer structure or a multi-layer structure. The first insulating layer GI1 may include silicon oxide.

The first gate electrode GE1 may be located on the first insulating layer GI1. A second insulating layer GI2 may be located on the first insulating layer GI1 to cover the first gate electrode GE1. The second insulating layer GI2 may be an inorganic layer and/or an organic layer, and may have a single-layer structure or a multi-layer structure. The second insulating layer GI2 may include silicon nitride.

The back gate electrode BGE1 may be located on the second insulating layer GI2. A third insulating layer ILD1 may be located on the second insulating layer GI2 to cover the back gate electrode BGE1. The third insulating layer ILD1 may be an inorganic layer and/or an organic layer, and may have a single-layer structure or a multi-layer structure. The third insulating layer ILD1 may include the same material as the second insulating layer GI2. The third insulating layer ILD1 may include silicon nitride.

The second semiconductor pattern OACT may be located on the third insulating layer ILD1. According to some embodiments, the second semiconductor pattern OACT may include an oxide semiconductor. For example, the second semiconductor pattern OACT may include a metal oxide such as zinc (Zn), indium (In), gallium (Ga), tin (Sn), or titanium (Ti), or a mixture of a metal such as zinc (Zn), indium(In), gallium(Ga), tan (Sn), titanium (Ti) and an oxide thereof.

The second semiconductor pattern OACT may overlap the back gate electrode BGE1 on a plane (or in a plan view). According to some embodiments of the present invention, an additional metal electrode may be further located between the second semiconductor pattern OACT and the back gate electrode BGE1.

An insulating pattern ILP may be located on the third insulating layer ILD1 to cover a channel region of the second semiconductor pattern OACT. A second gate electrode GE2 may be located over the insulating pattern ILP. However, embodiments of the present invention are not limited thereto. According to some embodiments of the present invention, the insulating layer may be entirely arranged to cover an upper surface of the third insulating layer ILD1 and the second semiconductor pattern OACT, and the second gate electrode GE2 may be arranged over the insulating layer. In this case, a contact hole exposing the source region and the drain region of the second semiconductor pattern OACT may be formed in the insulating layer.

A fourth insulating layer ILD2 may be located on the third insulating layer ILD1 to cover the second semiconductor pattern OACT and the second gate electrode GE2. The fourth insulating layer ILD2 may be an inorganic layer and/or an organic layer, and may have a single-layer structure or a multi-layer structure. The fourth insulating layer ILD2 may include at least one of aluminum oxide, titanium oxide, silicon oxide, silicon nitride, silicon oxynitride, zirconium oxide, or hafnium oxide.

First connection electrodes CNE11, CNE12, CNE13, and CNE14 may be located on the fourth insulating layer ILD2. The first connection electrodes CNE11 and CNE12 may be connected to the first semiconductor patterns ACT through a contact hole penetrating the first to fourth insulating layers GI1, GI2, ILD1, and ILD2. The first connection electrodes CNE13 and CNE14 may be connected to the second semiconductor patterns OACT through a contact hole penetrating the fourth insulating layer ILD2.

A fifth insulating layer VIA1 may be located on the fourth insulating layer ILD2 to cover the first connection electrodes CNE11, CNE12, CNE13, and CNE14. The fifth insulating layer VIA1 may be an inorganic layer and/or an organic layer, and may have a single-layer structure or a multi-layer structure. The fifth insulating layer VIA1 may include at least one of aluminum oxide, titanium oxide, silicon oxide, silicon nitride, silicon oxynitride, zirconium oxide, or hafnium oxide.

Second connection electrodes CNE21 and CNE22 may be located on the fifth insulating layer VIA1. The second connection electrode CNE21 may be connected to the first connection electrode CNE11 through a contact hole penetrating the fifth insulating layer VIA1. The second connection electrode CNE22 may face the first connection electrode CNE14 with the fifth insulating layer VIA1 interposed therebetween.

A sixth insulating layer VIA2 may be located on the fifth insulating layer VIA1 to cover the second connection electrodes CNE21 and CNE22. The sixth insulating layer VIA2 may be an inorganic layer and/or an organic layer, and may have a single-layer structure or a multi-layer structure. The sixth insulating layer VIA2 may include at least one of aluminum oxide, titanium oxide, silicon oxide, silicon nitride, silicon oxynitride, zirconium oxide, or hafnium oxide.

The display element layer DP-ED may be located on the circuit element layer DP-CL. The display element layer DP-ED may include a pixel defining layer PDL and the light-emitting element ED.

The pixel defining layer PDL may be located on the sixth insulating layer VIA2 of the circuit element layer DP-CL. A light-emitting opening EOP may be defined (or may be provided) in the pixel defining layer PDL. The light-emitting opening EOP may correspond to the first electrode AE (i.e., the anode) of the light-emitting element ED, and the pixel defining layer PDL may expose at least a portion of the first electrode AE of the light-emitting element ED through the light-emitting opening EOP.

The pixel defining layer PDL may include an inorganic insulating material. For example, the pixel defining layer PDL may include silicon nitride.

The light-emitting element ED may include the first electrode AE, a light-emitting layer EL, and a second electrode CE (that is, a cathode).

The first electrode AE may be located on the sixth insulating layer VIA2 of the circuit element layer DP-CL. The first electrode AE may be a transmissive electrode, a semi-transmissive electrode, or a reflective electrode. The first electrode AE may include a single layer structure or a multi-layer structure. The first electrode AE may include a plurality of layers including ITO and Ag. For example, the first electrode AE may include a layer (hereinafter, a lower ITO layer) including ITO, a layer (hereinafter, an Ag layer) including Ag located on the lower ITO layer, and a layer (hereinafter, a upper ITO layer) including ITO located on the Ag layer. However, embodiments of the present invention are not limited thereto, for example the first electrode AE may be provided as a single layer.

The light-emitting layer EL may be located on the first electrode AE. The light-emitting layer EL may be referred to as an 'organic layer' or an 'intermediate layer'. The light-emitting layer EL may cover a part of the upper surface of the pixel defining layer PDL.

The second electrode CE may be located on the light-emitting layer EL. The second electrode CE may cover the light-emitting layer EL. The second electrode CE may be commonly located in the pixels PX (see FIG. 6). That is, the second electrode CE may be commonly arranged on the light-emitting layers EL of the pixels PX.

The thin film encapsulation layer TFE may be located on the light-emitting element ED. The thin film encapsulation layer TFE may include an inorganic layer, an organic layer, and an inorganic layer sequentially stacked. The inorganic layers comprise an inorganic material and are capable of protecting the pixels from moisture/oxygen. The organic layer includes an organic material, and may protect the pixels PX from a foreign material such as dust particles.

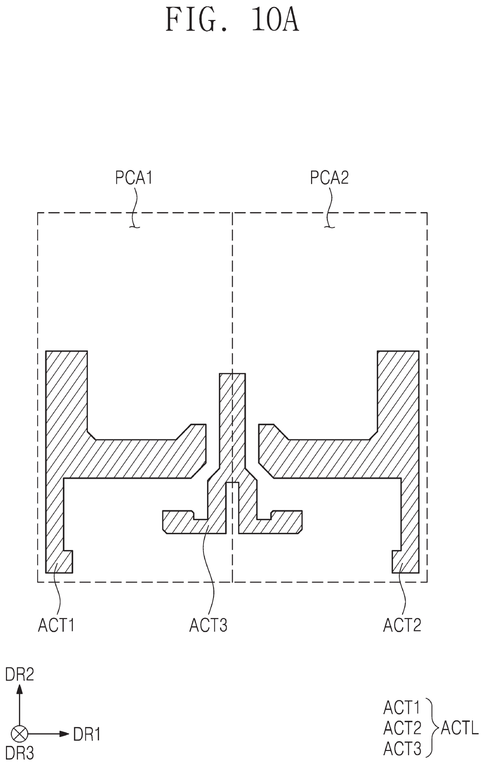

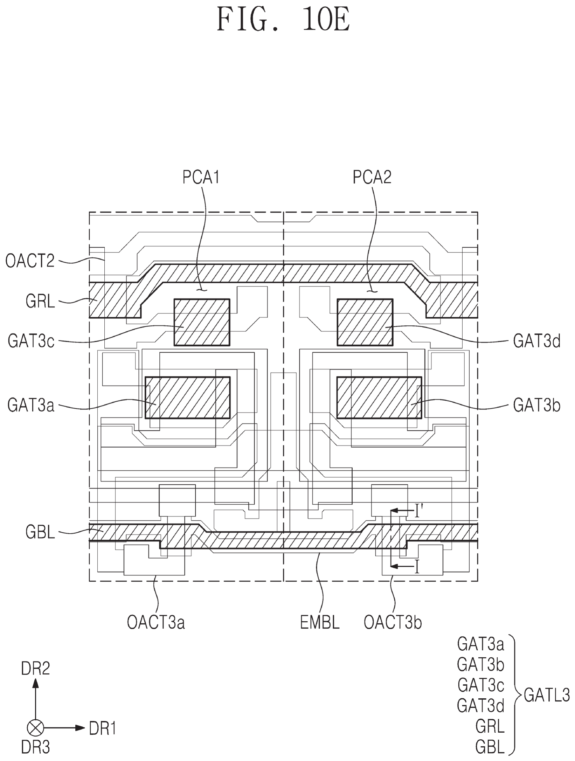

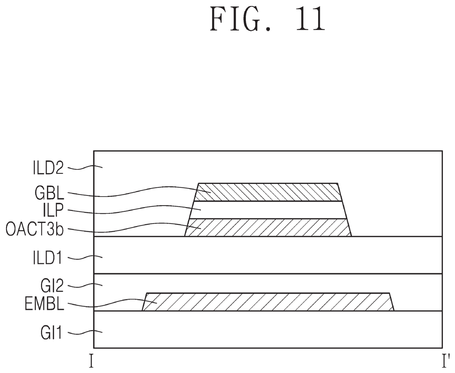

FIGS. 10A to 10G are plan views illustrating a manufacturing process of a display panel according to some embodiments of the present invention. FIG. 11 is a cross-sectional view taken along a cutting line I-I' shown in FIG. 10E.

FIGS. 10A to 10G illustrate two circuit regions (that is, first and second circuit regions PCA1 and PCA2) in which two pixel circuits (that is, referred to as a first pixel circuit and a second pixel circuit) among the plurality of pixel circuits PC (see FIG. 7A) provided in the display panel DP are respectively arranged . The first and second circuit regions PCA1 and PCA2 are adjacent to each other in the first direction DR1.

Referring to FIG. 10A, a first semiconductor pattern layer ACTL may be located on the buffer layer BFL illustrated in FIG. 9. The first semiconductor pattern layer ACTL may include a plurality of first-first to first-third semiconductor patterns ACT1, ACT2, and ACT3 spaced apart from each other. According to some embodiments, the first-first to first-third semiconductor patterns ACT1, ACT2, and ACT3 are spaced apart from each other in the first direction DR1. The first-first semiconductor pattern ACT1 is located in the first circuit region PCA1, and the first-second semiconductor pattern ACT2 is located in the second circuit region PCA2. The first-third semiconductor pattern ACT3 may have a shape that overlaps the first and second circuit regions PCA1 and PCA2 and is linearly symmetric with respect to a virtual axis located at a boundary between the first and second circuit regions PCA1 and PCA2. The first-first and first-second semiconductor patterns ACT1 and ACT2 may be linearly symmetrical with respect to the virtual axis.

In FIG. 10A, example shapes of the first-first to first-third semiconductor patterns ACT1, ACT2, and ACT3 are illustrated, and shapes of the first-first to first-third semiconducting patterns ACT1, ACT2, and ACT3 may be variously changed according to a pixel circuit design, and embodiments are not limited thereto.

According to some embodiments, the first semiconductor pattern layer ACTL may include a crystalline semiconductor material. For example, the first semiconductor pattern layer ACTL may include a polycrystalline semiconductor material such as polycrystalline silicon.

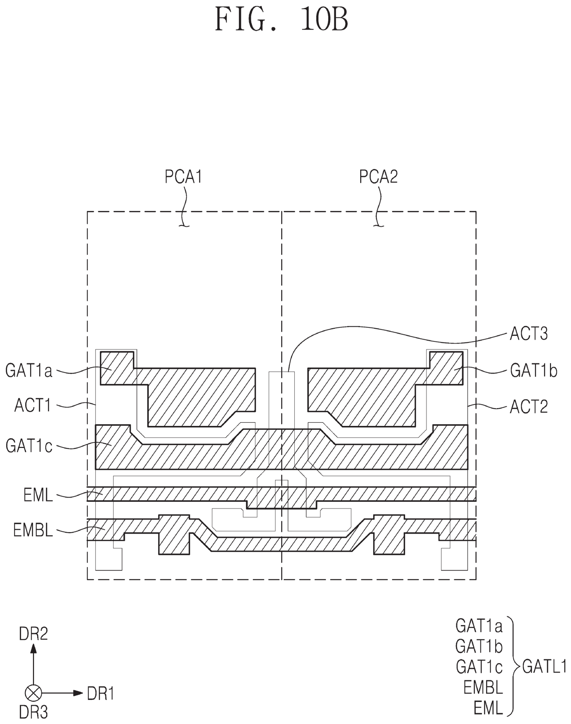

Referring to FIGS. 10A and 10B, the first semiconductor pattern layer ACTL is covered by the first insulating layer GI1 illustrated in FIG. 9, and a first gate electrode layer GATL1 may be located on the first insulating layer GI1. The first gate electrode layer GATL1 may include a plurality of patterns GAT1a, GAT1b, and GAT1c. The first-first gate electrode pattern GAT1a and the first-second gate electrode pattern GAT1b may be spaced apart from each other in the first direction DR1. The first-first gate electrode pattern GAT1a and the first-second gate electrode pattern GAT1b may be linearly symmetrical to each other with respect to virtual axis located at the boundary between the first and second circuit regions PCA1 and PCA2. The first-third gate electrode pattern GAT1c may have a bar shape extending along the first direction DR1. The first-third gate electrode pattern GAT1c may have a shape symmetrical to the virtual axis.

The first-first gate electrode pattern GAT1a and the first-second gate electrode pattern GAT1b may overlap the first-first semiconductor pattern ACT1 and the first-second semiconductor pattern ACT2, respectively, on a plane (or in a plan view). The first-first gate electrode pattern GAT1a may form a first electrode of the first capacitor C1 (see FIG. 7A) in the first circuit region PCA1, and the first-second gate electrode pattern GAT1b may form a first electrodes of the first capacitors C1 in the second circuit region PCA2.

The first-third gate electrode pattern GAT1c overlaps the first-first semiconductor pattern ACT1 and the first-second semiconductor pattern ACT2 on a plane (or in a plan view). The first-third gate electrode pattern GAT1c may form a first electrode of the second capacitors C2 (see FIG. 7A) of the first pixel circuit in the first circuit region PCA1 and form a first electrode of the second capacitors C2 of the second pixel circuit in the second circuit region PCA2.

The first gate electrode layer GATL1 may further include first and second light-emitting control lines EMBL and EML. The first and second light-emitting control lines EMBL and EML extend in the first direction DR1 and may be spaced apart from each other in the second direction DR2. The first light-emitting control line EMBL overlaps the first-first semiconductor pattern ACT1 and the first-second semiconductor pattern ACT2 on a plane (or in a plan view). The first light-emitting control line EMBL overlapping the first-first semiconductor pattern ACT1 in the first circuit region PCA1 may be utilized as a gate electrode of the first light-emitting control transistor ET1 (see FIG. 7A) included in the first pixel circuit. The first light-emitting control line EMBL overlapping the first-second semiconductor pattern ACT2 in the second circuit region PCA2 may be utilized as a gate electrode of the first light-emitting control transistor ET1 included in the second pixel circuit.

The second light-emitting control line EML overlaps the first-third semiconductor patterns ACT3 on a plane (or in a plan view). The second light-emitting control line EML overlapping the first-third semiconductor pattern ACT3 in the first circuit region PCA1 may be utilized as a gate electrode of the second light-emitting control transistor ET2 (see FIG. 7A) included in the first pixel circuit. The second light-emitting control line EML overlapping the first-third semiconductor pattern ACT3 in the second circuit region PCA2 may be utilized as a gate electrode of the second light-emitting control transistor ET2 included in the second pixel circuit.

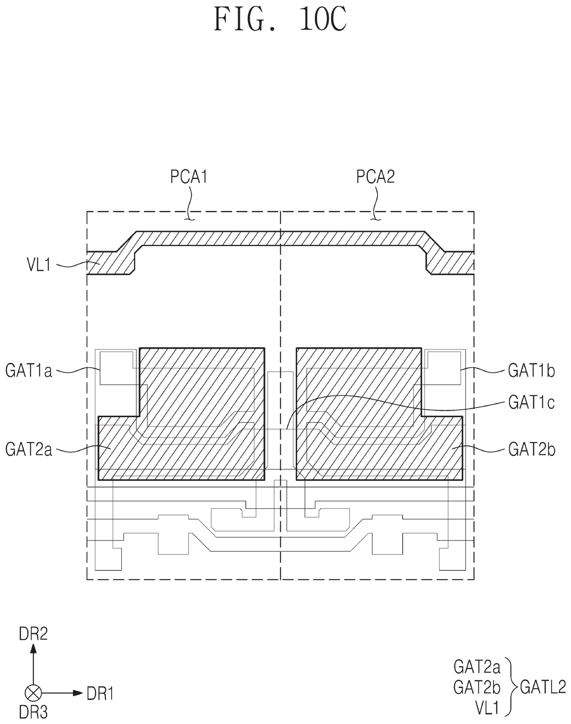

Referring to FIGS. 10B and 10C, the first gate electrode layer GATL1 may be covered by the second insulating layer GI2 (see FIG. 9), and a second gate electrode layer GALT2 may be located on the second insulating layerGI2. The second gate electrode layer GATL2 may include a plurality of patterns GAT2a and GAT2b. The second-first gate electrode pattern GAT2a and the second-second gate electrode pattern GAT2b may be spaced apart from each other in the first direction DR1. The second-first gate electrode pattern GAT2a and the second-second gate electrode pattern GAT2b may be linearly symmetrical to each other with respect to the virtual axis located at the boundary between the first and second circuit regions PCA1 and PCA2.

The second-first gate electrode pattern GAT2a overlaps with the first-first gate electrode pattern GAT1a and the first-third gate electrode patterns GAT1c in the first circuit region PCA1, and the second-second gate electrode pattern GAT2b overlaps with the first-second gate electrode patterns GAT1b and the first-third gate electrode patterns GAT1c in the second circuit region PC A2. The second-first gate electrode pattern GAT2a forms the second electrode of the first capacitor C1 (see FIG. 7A) (or the back gate electrode BGE1 of the first transistor T1) included in the first pixel circuit in the first circuit region PCA1. The second-second gate electrode pattern GAT2b forms the second electrode of the first capacitor C1 (or the back gate electrode BGE1 of the first transistor T1) included in the second pixel circuit in the second circuit region PCA2.

The second gate electrode layer GATL2 further includes a reference voltage line VL1 extending in the first direction DR1. The reference voltage line VL1 may be connected to the third transistor T3 (see FIG. 7A) in the first and second circuit regions PCA1 and PCA2.

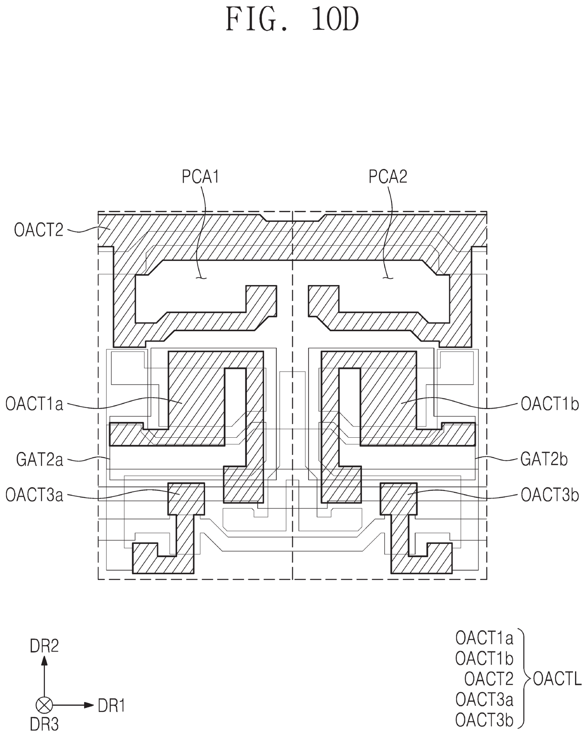

Referring to FIGS. 10C and 10D, the second gate electrode layer GATL2 may be covered by the third insulating layer ILD1 (see FIG. 9), and a second semiconductor pattern layer OACTL may be located on the third insulating layer ILD1. According to some embodiments, the second semiconductor pattern layer OACTL may include an oxide semiconductor. For example, the second semiconductor pattern layer OACTL may include a metal oxide such as zinc (Zn), indium (In), gallium (Ga), tin (Sn), or titanium (Ti), or a mixture of a metal such as zinc (Zn), indium (In), gallium (Ga), tan (Sn), and titanium (Ti) and an oxide thereof.

The second semiconductor pattern layer OACTL may include a plurality of second-first to second-fifth semiconductor patterns OACT1a, OACT1b, OACT2, OACT3a, and OACT3b spaced apart from each other. The second-first and second-second semiconductor patterns OACT1a and OACT1b are spaced apart from each other in the first direction DR1. The second-first semiconductor pattern OACT1a is located in the first circuit region PCA1, and the second-second semiconductor pattern OACT1b is located in the second circuit region PCA2. The second-first and second-second semiconductor patterns OACT1a and OACT1b are linearly symmetrical to each other with respect to the virtual axis located at the boundary between the first and second circuit regions PCA1 and PCA2.

The second-first semiconductor pattern OACT1a overlaps the second-first gate electrode pattern GAT2a on a plane (or in a plan view) in the first circuit region PCA1, and the second-second semiconductor pattern OACT1b overlaps the second-second gate electrode pattern GAT2b on a plane (or in a plan view) in the second circuit region PCA2.

The second-third semiconductor pattern OACT2 overlaps the first and second circuit regions PCA1 and PCA2 on a plane (or in a plan view) and has a linearly symmetric shape with respect to the virtual axis. The second-fourth and second-fifth semiconductor patterns OACT3a and OACT3b are spaced apart from each other in the first direction DR1. The second-fourth and second-fifth semiconductor patterns OACT3a and OACT3b are located in the first and second circuit regions PCA1 and PCA2, respectively. The second-fourth and second-fifth semiconductor patterns OACT3a and OACT3b are linearly symmetrical to each other with respect to the virtual axis located at the boundary between the first and second circuit regions PCA1 and PCA2.

Referring to FIGS. 10D and 10E, the second semiconductor pattern layer OACTL is partially covered by the insulating pattern ILP (see FIG. 9), and the third gate electrode layer GATL3 may be located on the insulating pattern ILP.

The third gate electrode layer GATL3 may include a plurality of patterns GAT3a, GAT3b, GAT3c, and GAT3d. The third-first gate electrode pattern GAT3a and the third-second gate electrode patterns GAT3b may be spaced apart from each other in the first direction DR1. The third-first gate electrode pattern GAT3a and the third-second gate electrode pattern GAT3b may be linearly symmetrical to each other with respect to the virtual axis located at the boundary between the first and second circuit regions PCA1 and PCA2. The third-first gate electrode pattern GAT3a overlaps the second-first semiconductor pattern OACT1a in the first circuit region PCA1 on a plane (or in a plan view), and the third-second gate electrode pattern GAT3b overlaps the second-second semiconductor pattern OACT 1b in the second circuit region PCA2 on a plane (or in a plan view). The third-first gate electrode pattern GAT3a forms a gate electrode of the first transistor T1 (see FIG. 7A) included in the first pixel circuit, and the third-second gate electrode pattern GAT3b forms a gate electrode of the first transistor T1 included in the second pixel circuit.

The third-third gate electrode pattern GAT3c and the third-fourth gate electrode pattern GAT3d may be spaced apart from each other in the first direction DR1. The third-third gate electrode pattern GAT3c and the third-fourth gate electrode pattern GAT3d may be linearly symmetrical to each other with respect to the virtual axis located at the boundary between the first and second circuit regions PCA1 and PCA2. The third-third gate electrode pattern GAT3c overlaps with the second-third semiconductor pattern OACT2 in the first circuit region PCA1 on a plane (or in a plan view), and the third-fourth gate electrode pattern GAT3d overlaps with the second-third semiconductor pattern OACT2 in the second circuit region PCA2 on a plane (or in a plan view). The third-third gate electrode pattern GAT3c forms a gate electrode of the second transistor T2 (see FIG. 7A) included in the first pixel circuit, and the third-fourth gate electrode pattern GAT3d forms the gate electrode of the second transistor T2 included in the second pixel circuit.

The third gate electrode layer GATL3 may further include a reference scan line GRL and a black scan line GBL. The reference scan line GRL and the black scan line GBL extend in the first direction DR1 and may be spaced apart from the patterns GAT3a, GAT3b, GAT3c, and GAT3d in the second direction DR2.

The reference scan line GRL overlaps the second-third semiconductor pattern OACT2 in the first and second circuit regions PCA1 and PCA2 on a plane (or in a plan view). The reference scan line GRL forms a gate electrode of the third transistor T3 (see FIG. 7A) included in the first pixel circuit in the first circuit region PCA1, and forms a gate electrode of the third transistor T3 included in the second pixel circuit in the second circuit region PCA2.

The black scan line GBL overlaps the second-fourth semiconductor pattern OACT3a in the first circuit region PCA1 on a plane (or in a plan view), and overlaps the second-fifth semiconductor pattern OACT3b in the second circuit region PCA2 on a plane (or in a plan view). The black scan line GBL forms a gate electrode of the fourth transistor T4 (see FIG. 7A) included in the first pixel circuit in the first circuit region PCA1, and forms a gate electrode of the fourth transistor T 4 included in the second pixel circuit in the second circuit region PCA2.

Referring to FIGS. 10E and 11, the black scan line GBL may overlap the first light-emitting control line EMBL on a plane (or in a plan view). Accordingly, the width of the first and second circuit regions PCA1 and PCA2 in the second direction DR2 may be reduced by a width at which the black scan line GBL and the first light-emitting control line EMBL overlap. In this way, when the black scan line GBL and the first light-emitting control line EMBL overlap each other, the space required to form the pixel circuit can be reduced.

The first light-emitting control line EMBL is located on the first insulating layer GI1, and the black scan line GBL is located on the insulating pattern ILP. In the cross-sectional view, the second-fourth and second-fifth semiconductor patterns OACT3a and OACT3b may be located between the black scan line GBL and the first light-emitting control line EMBL. In this case, the first light-emitting control line EMBL may serve as the back gate electrode BGE4 (see FIG. 7A) of the fourth transistor T4 (see FIG. 7A).

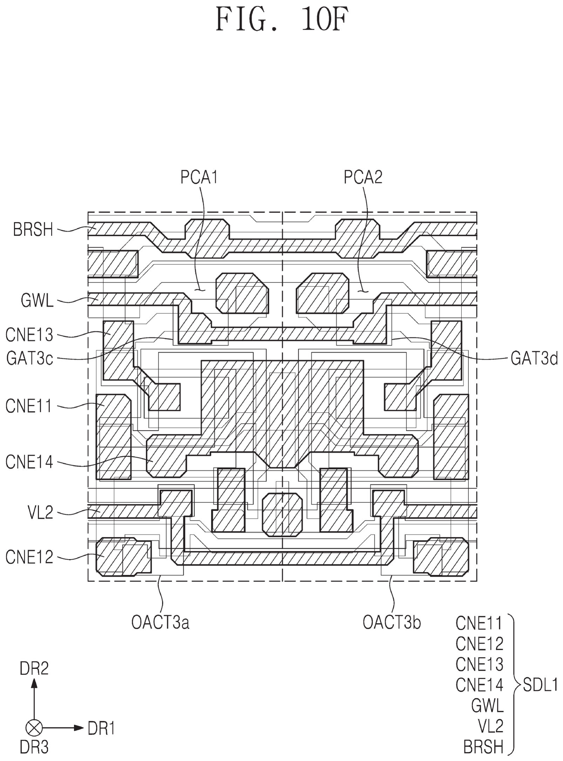

Referring to FIGS. 10E and 10F, the third gate electrode layer GATL3 may be covered by the fourth insulating layer ILD2 (see FIG. 9), and a first data electrode layer SDL1 may be located on the fourth insulating layer 1LD2.

The first data electrode layer SDL1 may include a plurality of connection electrodes CNE11, CNE12, CNE13, and CNE14. The plurality of connection electrodes CNE11, CNE12, CNE13, and CNE14 may be electrically connected to patterns or lines located below the plurality of connection electrodes CNE11, CNE12, CNE13, and CNE14. Each of the plurality of connection electrodes CNE11, CNE12, CNE13, and CNE14 may have an island shape.

The first data electrode layer SDL1 may further include a write scan line GWL and an initialization voltage line VL2. The write scan line GWL and the initialization voltage line VL2 extend in the first direction DR1 and may be spaced apart from each other with the plurality of connection electrodes CNE11, CNE12, CNE13, and CNE14. The write scan line GWL is connected to the third-third gate electrode pattern GAT3c in the first circuit region PCA1, and is connected to the third-fourth gate electrode pattern GAT3d in the second circuit region PCA2. The initialization voltage line VL2 is connected to the second-fourth semiconductor pattern OACT3a in the first circuit region PCA1, and is connected to the second-fifth semiconductor pattern OACT3b in the second circuit region PCA2.

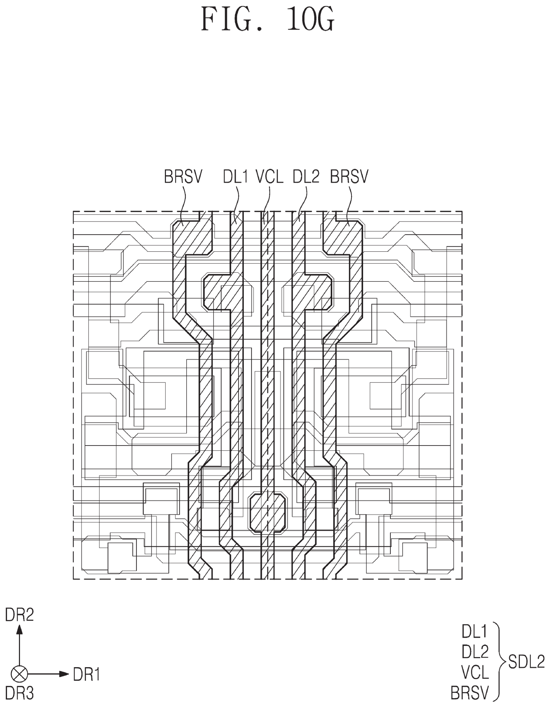

The first data electrode layer SDL1 may further include a horizontal connection line BRSH. The horizontal connection line BRSH may be a line connected to the vertical connection line BRSV illustrated in FIG. 10G. The horizontal connection line BRSH may be a line electrically connecting the vertical connection line BRSV and a data line corresponding to the vertical connection line BRSV.

Referring to FIGS. 10F and 10G, the first data electrode layer SDL1 may be covered by the fifth insulating layer ViA1 (see FIG. 9), and the second data electrode layer SDL2 may be located on the fifth insulating layer VIA1.

The second data electrode layer SDL2 may include first and second data lines DL1 and DL2, a voltage connection line VCL, and the vertical connection line BRSV. The first and second data lines DL1 and DL2, the voltage connection line VCL, and the vertical connection line BRSV extend in the second direction DR2 and may be spaced apart from each other in the first direction DR1.

The first data line DL1 is connected to the second transistor T2 (see FIG. 7A) included in the first pixel circuit, and the second data line DL2 is connected to the second transistor T2 included in the second pixel circuit. The voltage connection line VCL may be electrically connected to the reference voltage line VL1 or the initialization voltage line VL2. The vertical connection line BRSV may be electrically connected to the horizontal connection line BRSH.

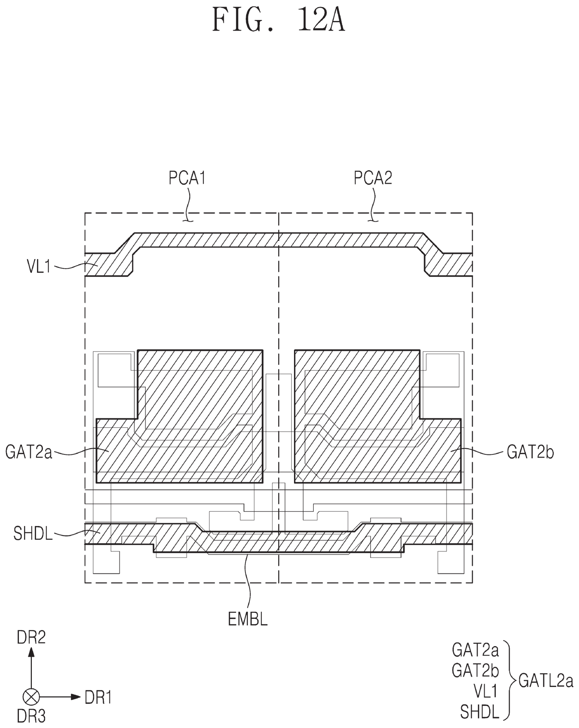

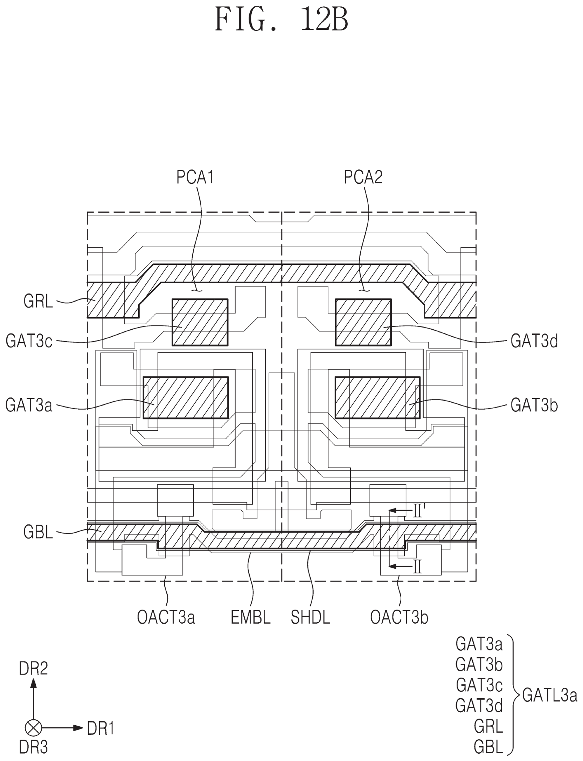

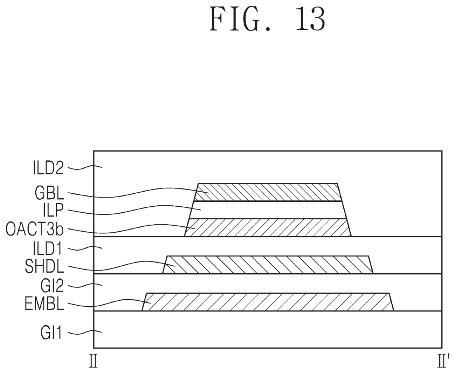

FIGS. 12A and 12B are plan views illustrating a manufacturing process of a display panel according to some embodiments of the present invention. FIG. 13 is a cross-sectional view taken along a cutting line II-II' shown in FIG. 12B. Among the components illustrated in FIGS. 12A and 12B, the same components as those illustrated in FIGS. 10C and 10E are denoted by the same reference numerals, and a detailed description thereof is omitted.

Referring to FIG. 12A, the second gate electrode layer GATL2a further includes a shielding line SHDL extending in the first direction DR1. The shield line SHDL may overlap the first light-emitting control line EMBL on a plane (or in a plan view).

Referring to FIG. 12B, the third gate electrode layer GATL3a may further include a black scan line GBL extending in the first direction DR1. The black scan line GBL overlaps the second-fourth semiconductor pattern OACT3a in the first circuit region PCA1 on a plane (or in a plan view), and overlaps the second-fifth semiconductor pattern OACT3b in the second circuit region PCA2 on a plane (or in a plan view). The black scan line GBL forms a gate electrode of the fourth transistor T4 (see FIG. 7A) included in the first pixel circuit in the first circuit region PCA1, and forms a gate electrode in the fourth transistor T4 included in the second pixel circuit in the second circuit region PCA2.

The black scan line GBL may overlap the first light-emitting control line EMBL and the shielding line SHDL on a plane (or in a plan view).

As shown in FIG. 13, the shield line SHDL may be further located between the first light-emitting control line EMBL and the black scan line GBL. The shielding line SHDL may be located on the second insulating layer GI2. The shielding line SHDL may mitigate signal interference between the first light-emitting control line EMBL and the black scan line GBL.

In the cross-sectional view, the second-fourth and second-fifth semiconductor patterns OACT3a and OACT3b may be located between the black scan line GBL and the shielding line SHDL. In this case, the shielding line SHDL may serve as the back gate electrode BGE4a (see FIG. 7B) of the fourth transistor T4 (see FIG. 7B). According to some embodiments of the present invention, the shielding line SHDL may be electrically connected to the black scan line GBL. The back gate electrode BGE4a of the fourth transistor T4 may receive the black scan signal GBi in the same manner as the gate electrode of the fourth transistorT4.

Although FIGS. 12A to 13 illustrate embodiments in which the shielding line SHDL is included in the second gate electrode layer GATL2a, the present invention is not limited to this embodiment. Alternatively, an additional metal layer for forming the shielding line SHDL may be further located between the second gate electrode layer GATL2a and the third gate electrode layer GALT3.

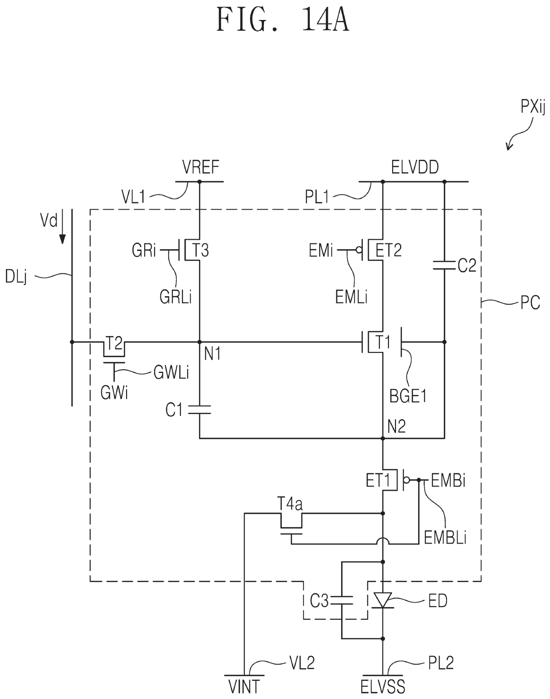

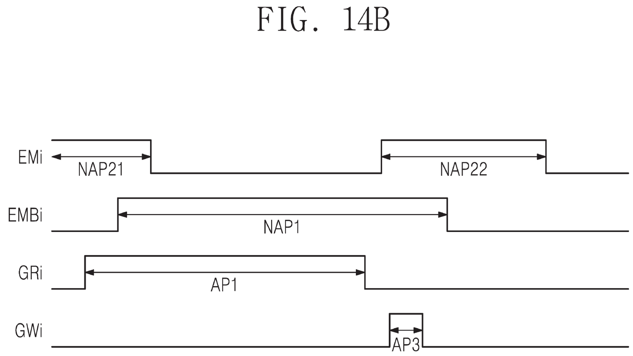

FIG. 14A is a circuit diagram of a pixel according to some embodiments of the present invention, and FIG. 14B is a waveform diagram illustrating signals applied to the pixel shown in FIG. 14A. Among the components illustrated in FIGS. 14A and 14B, the same components as those illustrated in FIGS. 7A and 7B are denoted by the same reference numerals, and some detailed description thereof may be omitted. Although FIG. 14A illustrates various components in a pixel according to some embodiments, embodiments according to the present disclosure are not limited thereto, and according to various embodiments, the pixel may include additional components, or fewer components, without departing from the scope of embodiments according to the present disclosure.

Referring to FIG. 14A, the pixel PXij may be connected to the data line DLj, the write scan line GWLi, the reference scan line GRLi, the first light-emitting control line EMBLi, and the second light-emitting control line EMLi.

The pixel PXij may include a light-emitting element ED and a pixel circuit PC. The pixel circuit PC includes first to fourth transistors T1, T2, T3, and T4a, first and second light-emitting control transistors ET1 and ET2. According to some embodiments of the present invention, the first to fourth transistors T1, T2, T3, and T4a may be N-type transistor, and the first and second light-emitting control transistors ET1 and ET2 may be P-type transistor.

The fourth transistor T4a is connected between the first electrode of the light-emitting element ED and the initialization voltage line VL2, and receives the first light-emitting control signal EMBi as a shared control signal. The fourth transistor T4a may include a source connected to the initialization voltage line VL2, a drain connected to the first electrode of the light-emitting element ED, and a gate electrode that receives the first light-emitting control signal EMBi as the shared control signal. The gate electrode of the fourth transistor T4a may be connected to the first light-emitting control line EMBLi.

The first light-emitting control transistor ET1 is connected between the second node N2 and the first electrode of the light-emitting element ED, and receives the first light-emitting controlling signal EMBi as the shared control signal. The first light-emitting control transistor ET1 may include a drain connected to the second node N2, a source connected to the first electrode of the light-emitting element ED, and a gate electrode that receives the first light-emitting controlling signal EMBi as the shared control signal. The gate electrode of the first light-emitting control transistor ET1 may be connected to the first light-emitting control line EMBLi.

The fourth transistor T4a may be an N-type transistor, and the first light-emitting control transistor ET1 may be a P-type transistor. The gate electrode of the fourth transistor T4a and the gate electrode of the first light-emitting control transistor ET1 may be commonly connected to the first light-emitting control line EMBLi.

Referring to FIG. 14B, the active period of the first light-emitting control signal EMBi may be defined as a low level period, and the inactive period NAP1 may be defined as a high level period. During the inactive period NAP1 of the first light-emitting control signal EMBi, the first light-emitting control transistor ET1 may be turned off and the fourth transistor T4a may be turned on. That is, the first light-emitting control transistor ET1 and the fourth transistor T4a are alternately turned on.

In this way, by sharing one line between the fourth transistor T4a and the first light-emitting control transistor ET1 in each pixel PXij, the number of lines used to supply signals to each pixel PXij may be reduced.

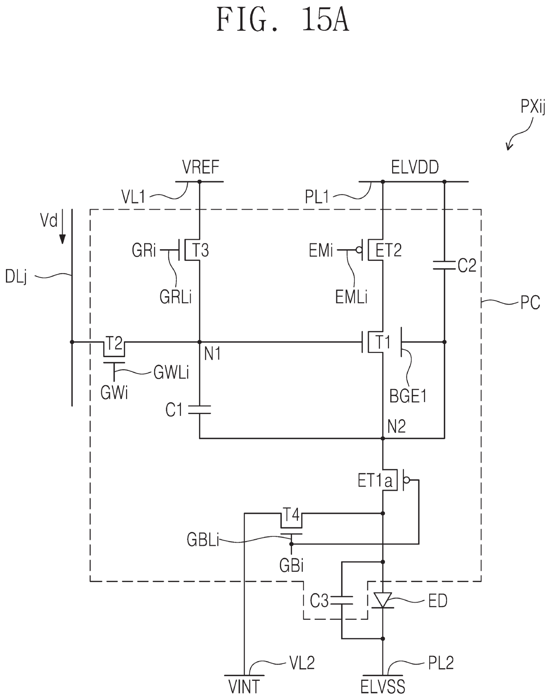

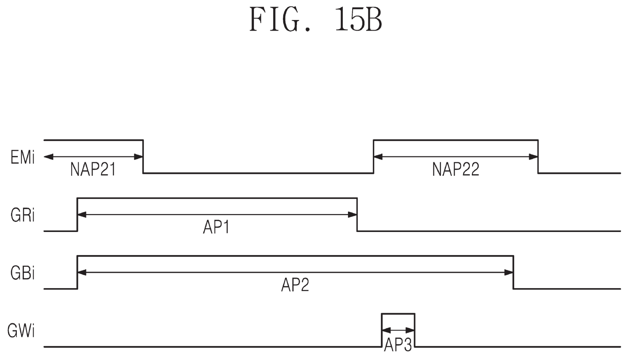

FIG. 15A is a circuit diagram of a pixel according to some embodiments of the present invention, and FIG. 15B is a waveform diagram showing signals applied to the pixel shown in FIG. 15A. Although FIG. 15A illustrates various components in a pixel according to some embodiments, embodiments according to the present disclosure are not limited thereto, and according to various embodiments, the pixel may include additional components, or fewer components, without departing from the scope of embodiments according to the present disclosure.

Referring to FIG. 15A, the pixel PXij may be connected to the data line DLj, the write scan line GWLi, the reference scan line GRLi, the black scan line GBLj, and the second light-emitting control line EMLi.

The pixel PXij may include a light-emitting element ED and a pixel circuit PC. The pixel circuit PC includes first to fourth transistors T1, T2, T3, and T4, first and second light-emitting control transistors ET1a and ET2. According to some embodiments of the present invention, the first to fourth transistors T1, T2, T3, and T4 may be N-type transistor, and the first and second light-emitting control transistors ET1a and ET2 may be P-type transistor.

The fourth transistor T4 is connected between the first electrode of the light-emitting element ED and the initialization voltage line VL2, and receives the black scan signal GBi as a shared control signal. The fourth transistor T4 may include a source connected to the initialization voltage line VL2, a drain connected to the first electrode of the light-emitting element ED, and a gate electrode that receives the black scan signal GBi as the shared control signal. The gate electrode of the fourth transistor T4 may be connected to the black scan line GBLi.

The first light-emitting control transistor ET1a is connected between the second node N2 and the first electrode of the light-emitting element ED, and receives the black scan signal GBi as the shared control signal. The first light-emitting control transistor ET1a may include a drain connected to the second node N2, a source connected to the first electrode of the light-emitting element ED, and a gate electrode that receives the black scan signal GBi as the shared control signal. The gate electrode of the first light-emitting control transistor ET1a may be connected to the black scan line GBLi.

The fourth transistor T4 may be an N-type transistor, and the first light-emitting control transistor ET1a may be a P-type transistor. The gate electrode of the fourth transistor T4 and the gate electrode of the first light-emitting control transistor ET1a may be commonly connected to the black scan line GBLi.

Referring to FIG. 15B, the active period AP2 of the black scan signal GBi may be defined as a high-level period, and the inactive period may be defined as a low-level period. During the active period AP2 of the black scan signal GBi, the fourth transistor T4 may be turned on, and the first light-emitting control transistor ET1a may be turned off. That is, the first light-emitting control transistor ET1a and the fourth transistor T4 are alternately turned on.

In this way, by sharing one line between the fourth transistor T4 and the first light-emitting control transistor ET1a in each pixel PXij, the number of lines used to supply signals to each pixel PXij may be reduced.

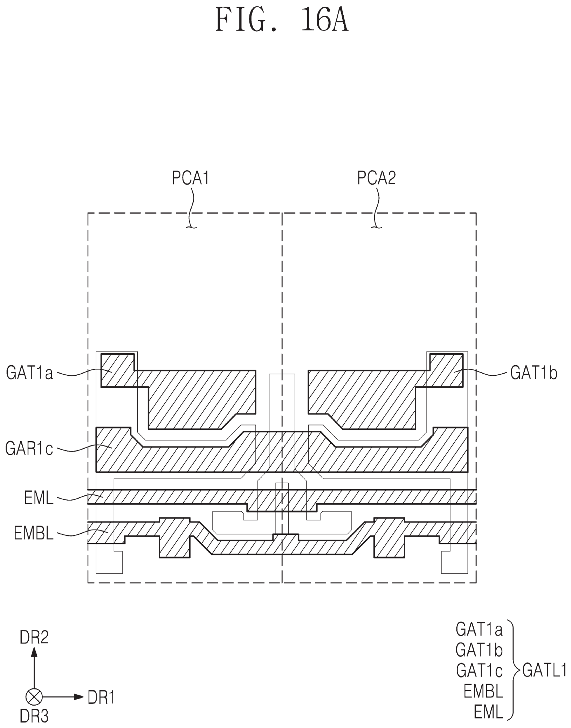

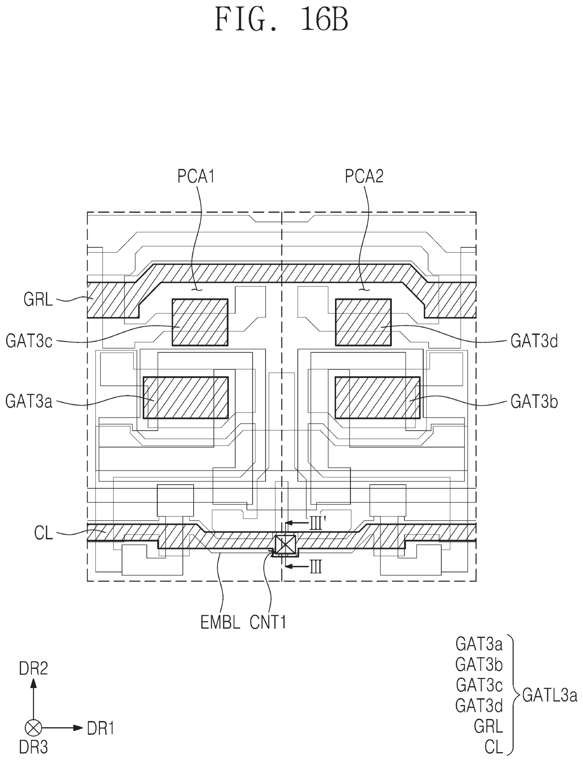

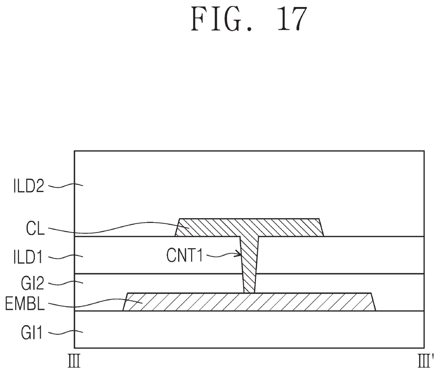

FIGS. 16A and 16B are plan views illustrating a manufacturing process of a display panel according to some embodiments of the present invention. FIG. 17 is a cross-sectional view taken along a cutting line III-III' shown in FIG. 16B. Among the components illustrated in FIGS. 16A and 16B, the same components as those illustrated in FIGS. 10B and 10E are denoted by the same reference numerals, and a detailed description thereof is omitted.

Referring to FIG. 16A, the first gate electrode layer GATL1 may include a plurality of patterns GAT1a, GAT1b, and GAT1c, and first and second light-emitting control lines EMBL and EML. The first and second light-emitting control lines EMBL and EML extend in the first direction DR1 and may be spaced apart from each other in the second direction DR2. A portion of the first light-emitting control line EMBL in the first circuit region PCA1 may be utilized as the gate electrode of the first light-emitting control transistor ET1 (see FIG. 7A) included in the first pixel circuit. A portion of the first light-emitting control line EMBL in the second circuit region PCA2 may be utilized as the gate electrode of the first light-emitting control transistor ET1 included in the second pixel circuit.

Referring to FIG. 16B, the third gate electrode layer GATL3a may include a plurality of patterns GAT3a, GAT3b, GAT3c, and GAT3d, a reference scan line GRL, and a connection line CL. The reference scan line GRL and the connection line CL extend in the first direction DR1 and may be spaced apart from the patterns GAT3a, GAT3b, GAT3c, and GAT3d in the second direction DR2. A portion of the connection line CL in the first circuit region PCA1 is utilized as a gate electrode of the fourth transistor T4 (see FIG. 7A) included in the first pixel circuit, and a portion of the connection lines CL in the second circuit region PCA2 is utilized as gate electrodes of the fourth transistors T4 included in the second pixel circuit.

Referring to FIGS. 16B and 17, the connection line CL may overlap the first light-emitting control line EMBL on a plane (or in a plan view). The connection line CL may be connected to the first light-emitting control line EMBL through a contact hole CNT1.

The first light-emitting control line EMBL is located on the first insulating layer GI1 and is covered by the second insulating layer GI2. The connection line CL is located on the third insulating layer ILD1 and is connected to the first light-emitting control line EMBL through the contact hole CNT1 formed through the second and third insulating layers GI2 and ILD1. Therefore, the first light-emitting control line EMBL and the connection line CL may be electrically connected. In this case, the first light-emitting control line EMBL may serve as the back gate electrode BGE4 (see FIG. 7A) of the fourth transistor T4 (FIG. 7A).

In this way, when the fourth transistor T4 and the first light-emitting control transistor ET1a share one line in each pixel PXij, the space required to form the pixel circuit may be reduced compared to a structure in which the fourth transistor T 4 and the first light-emitting control transistor ET1a are respectively connected to independent lines.

As discussed, embodiments may provide a display device comprising: a display panel comprising a pixel, wherein the pixel comprises: a light-emitting element comprising a first electrode and a second electrode; a first transistor configured to operate in response to a potential of a first node and connected between a first power supply line and a second node; a second transistor coupled between a data line and the first node and configured to receive a write scan signal; a third transistor connected between the first node and a reference voltage line and configured to receive a reference scan signal; a first light-emitting control transistor connected between the second node and the first electrode of the light-emitting element and configured to receive a first light-emitting control signal through a first light-emitting control line; and a fourth transistor connected between the first electrode of the light-emitting element and an initialization voltage line and configured to receive a black scan signal through a black scan line, wherein an inactive period of the first light-emitting control signal is included in an active period of the black scan signal, and the first light-emitting control line overlaps the black scan line in a plan view.

The inactive period of the first light-emitting control signal may be entirely within the active period of the black scan signal.

Each of the first and fourth transistors may be a N-type transistor, and the first light-emitting control transistor may be a P-type transistor.

The first transistor may comprise a source electrode connected to the first power supply line, a drain electrode connected to the second node, and a gate electrode connected to the first node.

The first transistor may further comprise a back gate electrode connected to the second node.

The second transistor may comprise a source electrode connected to the data line, a drain electrode connected to the first node, and a gate electrode connected to a write scan line that is configured to receive a write scan signal.

The third transistor may comprise a source electrode connected to the reference voltage line, a drain electrode connected to the first node, and a gate electrode connected to a reference scan line that is configured to receive a reference scan signal.

The fourth transistor may comprise a source electrode connected to the initialization voltage line, a drain electrode connected to the first electrode of the light-emitting element, and a gate electrode connected to the black scan line.

The fourth transistor may comprise a back gate electrode connected to the first light-emitting control line.

The fourth transistor may comprise a back gate electrode electrically connected to its gate electrode and located on a different layer from the gate electrode.

The first light-emitting control transistor may comprise a source electrode connected to connected to the first electrode of the light-emitting element, a drain electrode connected to the second node, and a gate electrode connected to a first light- emitting control line.

The active period of the black scan signal may encompass an active period of the reference scan signal.

The active period of the black scan signal may have a longer duration that the active period of the reference scan signal.

A write scan signal active period may be non-overlapping with the active period of the reference scan signal.

The first light-emitting control line may be on a first metal layer and the black scan line may be on a second metal layer. An oxide semiconductor pattern may be interposed therebetween in cross-section at the overlap region. In the overlap region, the first light-emitting control line may serve as a back-gate electrode of the fourth transistor.

The pixel may further comprise a second light-emitting control transistor connected between the first power supply line and the first transistor and configured to receive a second light-emitting control signal. The source of the first transistor may be connected to the second light-emitting control transistor.

The second light-emitting control transistor may include a drain electrode connected to the first power supply line, a source electrode connected to the source electrode of the first transistor, and a gate electrode that receives a second light-emitting control signal. The gate electrode of the second light-emitting control transistor may be connected to a second light-emitting control line.

The pixel may comprise a first capacitor coupled between the first node and the second node; and a second capacitor coupled between the second node and the first power supply line.

The second electrode of the light-emitting element may be connected to a second power supply line, and the pixel may further comprise: a third capacitor connected between the first electrode of the light-emitting element and the second electrode of the light-emitting element.

Emboidments may provide a display device comprising: a display panel comprising a pixel, wherein the pixel comprises: a light-emitting element comprising a first electrode and a second electrode; a first transistor operating in response to a potential of a first node and connected between a first power supply line and a second node; a second transistor coupled between a data line and the first node and configured to receive a write scan signal; a third transistor connected between the first node and a reference voltage line and configured to receive a reference scan signal; a first light-emitting control transistor connected between the second node and the first electrode of the light-emitting element and configured to receive a shared control signal; and a fourth transistor connected between the first electrode of the light-emitting element and an initialization voltage line and configured to receive the shared control signal, wherein each of the first and fourth transistors is a N-type transistor, and the first light-emitting control transistor is a P-type transistor.

According to some embodiments of the present disclosure, in a structure in which the fourth transistor and the first light-emitting control transistor are composed of transistors of different types, the first light-emitting control line for applying the light-emitting controlling signal to the first light-emitting control transistor may overlap on a plane (or in a plan view) with the black scan line for applying the black scan signal to the fourth transistor. As a result, even if the resolution of the display device increases, components and signal lines of each pixel may be efficiently arranged in a limited space.

In the above, description has been made with reference to embodiments of the inventive concept, but those skilled or of ordinary skill in the art may understand that various modifications and changes may be made to the inventive concept insofar as such modifications and changes do not depart from the technical scope of the inventive concept set forth in the claims to be described later.

Therefore, the technical scope of the inventive concept is not to be limited to the contents stated in the detailed description of the specification, but should be determined by the appended claims, and their equivalents.

## Claims

1. A display device comprising:
a display panel comprising a pixel, wherein the pixel comprises:
a light-emitting element comprising a first electrode and a second electrode;
a first transistor configured to operate in response to a potential of a first node and connected between a first power supply line and a second node;
a second transistor coupled between a data line and the first node, the second transistor being configured to receive a write scan signal;
a third transistor connected between the first node and a reference voltage line, the third transistor being configured to receive a reference scan signal;
a first light-emitting control transistor connected between the second node and the first electrode of the light-emitting element, the first light-emitting control transistor being configured to receive a first light-emitting control signal through a first light-emitting control line; and
a fourth transistor connected between the first electrode of the light-emitting element and an initialization voltage line, the fourth transistor being configured to receive a black scan signal through a black scan line,
wherein an inactive period of the first light-emitting control signal is included in an active period of the black scan signal, and
the first light-emitting control line overlaps the black scan line in a plan view.

2. The display device of claim 1, wherein the fourth transistor comprises:
a source coupled to the initialization voltage line;
a drain connected to the first electrode of the light-emitting element; and
a gate electrode connected to the black scan line.

3. The display device of claim 2, wherein the fourth transistor further comprises:
a back gate electrode connected to the first light-emitting control line.

4. The display device of claim 2, wherein the fourth transistor further comprises:
a back gate electrode electrically connected to the gate electrode and located on a different layer from the gate electrode.

5. The display device of claim 4, wherein the pixel further comprises:
a shielding line overlapping the first light-emitting control line and the black scan line in the plan view and between the first light-emitting control line and the black scan line on a cross section.

6. The display device of claim 5, wherein the back gate electrode of the fourth transistor extends from the shield line.

7. The display device of any one of claims 1 to 6, wherein
each of the first to fourth transistors is an N-type transistor, and the first light-emitting control transistor is a P-type transistor.

8. The display device of claim 7, wherein the black scan signal has a high level during the active period, and wherein the first light-emitting control signal has the high level during the inactive period.

9. The display device of claim 7, wherein the pixel further comprises:
a second light-emitting control transistor connected between the first power supply line and the first transistor and configured to receive a second light-emitting control signal,
the second light-emitting control transistor is a P-type transistor.

10. The display device of claim 9, wherein the pixel further comprises:
a first capacitor coupled between the first node and the second node; and
a second capacitor coupled between the second node and the first power supply line.

11. The display device of claim 10, wherein the first transistor comprises:
a source coupled to the second light-emitting control transistor;
a drain connected to the second node;
a gate electrode connected to the first node;
a back gate electrode connected to the second node.

12. The display device of claim 10, wherein the second electrode of the light-emitting element is connected to a second power supply line, and the pixel further comprises: a third capacitor connected between the first electrode of the light-emitting element and the second electrode of the light-emitting element.

13. An electronic apparatus comprising:
a display panel according to any one of claims 1 to 12.
